(19) Europäisches Patentamt / European Patent Office / Office européen des brevets

(11) **EP 3 391 507 B1**

(12) **FASCICULE DE BREVET EUROPEEN**

(45) Date de publication et mention
de la délivrance du brevet:
**20.11.2019 Bulletin 2019/47**

(21) Numéro de dépôt: **16874194.0**

(22) Date de dépôt: **14.12.2016**

(51) Int Cl.:
*H02J 13/00* *(2006.01)*          *H02J 3/00* *(2006.01)*
*G01R 19/00* *(2006.01)*          *G01R 21/00* *(2006.01)*

(86) Numéro de dépôt international:
**PCT/CA2016/051470**

(87) Numéro de publication internationale:
**WO 2017/100916 (22.06.2017 Gazette 2017/25)**

(54) **MISE À JOUR D'UNE TOPOLOGIE D'UN RÉSEAU DE DISTRIBUTION PAR RÉATTRIBUTION SUCCESSIVE DES COMPTEURS**

AKTUALISIEREN EINER TOPOLOGIE EINES VERTEILUNGSNETZES DURCH SUKZESSIVES NEUZUWEISEN DER ZÄHLER

UPDATING A TOPOLOGY OF A DISTRIBUTION NETWORK BY SUCCESSIVE REALLOCATION OF THE COUNTERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2015 CA 2915674**

(43) Date de publication de la demande:
**24.10.2018 Bulletin 2018/43**

(73) Titulaire: **Hydro-Québec**
**Montréal, QC H2Z 1A4 (CA)**

(72) Inventeurs:
• **LÉONARD, François**
**Montréal**
**Québec H1C 1B1 (CA)**

• **ZINFLOU, Arnaud**
**Longueuil**
**Québec J4N 0H1 (CA)**

(74) Mandataire: **Plasseraud IP**
**66, rue de la Chaussée d'Antin**
**75440 Paris Cedex 09 (FR)**

(56) Documents cités:
US-A1- 2012 229 089          US-A1- 2013 278 437
US-A1- 2014 012 524          US-A1- 2014 012 524
US-A1- 2015 241 482          US-A1- 2015 241 482
US-A1- 2015 241 488          US-A1- 2016 109 491
US-A1- 2016 109 497          US-A1- 2016 131 501
US-A1- 2016 131 501

## Description

### Domaine de l'invention

L'invention porte sur une méthode par système informatique de correction automatique et mise à jour d'une topologie d'un réseau de distribution électrique par réattribution successive des compteurs.

### Contexte

Lors de la mise en service d'un réseau de distribution tout comme lors de l'installation de compteurs électriques, il survient occasionnellement des erreurs d'attribution compteur à transformateur dans les inscriptions de la base de données descriptive du réseau de même que des erreurs d'inscription de géolocalisation. Le réseau évolue lorsque l'exploitant déplace le rattachement de certains compteurs afin d'équilibrer les charges entre les transformateurs disponibles avoisinants sans pour autant réaliser une inscription ou réaliser la bonne inscription dans la base de données. Le résultat est une base de données contenant une description écartée de la réalité et dont le nombre d'écarts s'accroit avec le temps. Les conséquences sont multiples : erreur d'équilibrage des charges entre transformateurs, erreur dans la planification de remplacement ou d'ajout de transformateurs, erreur ou perte de sensibilité dans la détection de non-conformités électriques. Il existe donc un besoin pour un exploitant d'avoir une méthode qui permettrait de continuellement mettre à jour la base de données décrivant le réseau.

Dans un réseau de distribution moderne, en plus des compteurs intelligents on peut retrouver une faible proportion de compteurs non-communicants (le plus souvent de types électromécaniques) qui n'ont pas la capacité de transmettre leur lecture de tension/consommation et des raccordements à tarifs forfaitaires sans compteur (ex. : éclairage urbain). À ces consommateurs légaux de puissance s'ajoute les subtilisations d'énergie. La méconnaissance de ces transits de puissance fait en sorte qu'il est difficile de balancer les calculs de flux d'énergie (ou les pertes) dans l'arborescence du réseau, soit du consommateur jusqu'au départ de ligne dans un poste (« feeder »). Toute méthode utilisant les fluctuations de puissance pour déterminer la topologie fonctionne en autant que la puissance transitée par un compteur offre un patron temporel qui se démarque des patrons des transits de puissances méconnus.

Statistiquement, en ordre décroissant d'influence, la tension mesurée par un compteur fluctue en fonction de la tension au départ de ligne (ex. commutation du changeur de prise), de la charge transitée par ce compteur, de la charge transitée par les autres compteurs rattachés au même transformateur et en fonction des charges transitées par les autres transformateurs raccordés sur la même ligne. Toute méthode utilisant les fluctuations de tension pour déterminer la topologie d'une ligne basse-tension fonctionne en autant que les charges transitées par un transformateur voisin aura moins d'impact sur la tension mesurée d'un compteur que la charge transitée par le transformateur auquel il est rattaché.

L'utilisation de l'information transmise lors d'une panne de courant sur une portion du réseau permet d'attribuer les compteurs affectés par cette panne à cette portion. Cette méthode a deux importantes lacunes. La première est que pour attribuer un compteur à un transformateur, il faut attendre une panne qui n'affecte que le réseau de ce transformateur. La seconde est que dans ce dernier cas, il y a une possibilité que ce soit le transformateur qui est surchargé et qu'il y aura déplacement d'un ou de plusieurs compteurs ayant pour résultat que la topologie déduite grâce à la panne est dite « temps moins un » (*t*-1) car elle correspond à la topologie précédente.

US 2015/0241482 (Sonderegger) intitulé « Smart Grid Topology Estimator » décrit une méthode qui corrèle les variations de tensions entre deux compteurs et détermine s'ils sont tous deux reliés à un même transformateur. Cette méthode démarre le processus d'attribution sans connaissance préalable du réseau. Elle comporte comme principales limitations que la similarité s'exerce entre les fluctuations de tensions de deux compteurs à la fois et que la fonction de similarité proposée est seulement la corrélation. Cette méthode ne localise pas temporellement le déplacement d'un rattachement de compteur. Cette méthode exige un effort de calcul considérable si l'on ne dispose pas des coordonnées de géolocalisation afin de restreindre à un voisinage donné le nombre de compteurs à corréler. Cette méthode préconise aussi la synchronisation temporelle des séries temporelles de mesures de tensions par corrélation afin de corriger les erreurs d'estampilles temporelles sur les données collectées des compteurs. Notons que cette synchronisation temporelle est non requise avec des équipements modernes bien configurés et que cette synchronisation peut même poser un problème en augmentant indûment la corrélation entre deux séries temporelles comparées en les désynchronisant malgré la véracité des estampilles temporelles.

US 9,285,242 (Arya et al.) intitulé « Determining a connectivity model in smart grids » décrit une méthode qui suit le flot d'énergie dans l'arborescence du réseau. Un inconvénient de cette méthode est qu'elle requiert des mesures relatives à la puissance aux différents nœuds de l'arborescence, soit aux transformateurs et aux lignes. Un autre inconvénient de cette méthode est que les subtilisations d'énergie et les compteurs non-communicants non rattachés au réseau de communication perturbent les mesures relatives à la puissance et compromettent le suivi d'écoulement de puissance. Un grave inconvénient est que cette méthode ne peut pas traiter le cas d'un compteur qui a une consommation de puissance en deçà de la somme des erreurs de mesure des autres compteurs qui consomment beaucoup de puissance et des fluctuations des pertes du réseau. Enfin, la méthode ne tient pas compte de la fluctuation des pertes dans les équipements qui elles sont fonction de la charge et la température ambiante.

US 9,214,836 (Flammer, III) intitulé « Power grid topology discovery via time correlation of passive measurement events » décrit une méthode qui détecte et classe les événements de fluctuations de tensions et les corrèlent de façon à déterminer si deux compteurs sont rattachés à un même transformateur. D'un point de vue traitement du signal, la méthode proposée n'exploite qu'une petite partie du signal, soit seulement les fluctuations ponctuelles importantes de tension qualifiées « d'événements » dans la description de la méthode. La classification des événements proposée par la méthode réduit l'information supportée par plusieurs enregistrements temporels de mesure de tension à un ensemble de caractéristiques correspondant au classement attribué : cette réduction ne crée pas de l'information, elle en efface et peut de la sorte introduire une imprécision dans l'analyse subséquente. La méthode ne regroupe pas l'information commune à plusieurs compteurs attribués à un même transformateur de façon à la comparer à un compteur pour déterminer si celui-ci est aussi rattaché au même transformateur : un tel regroupement d'information (par la réalisation d'une moyenne par exemple) aurait réduit la dispersion inhérente de l'information prise individuellement de chaque compteur.

US 2016/0131501 (Steigler) intitulé « Correlating meter data to detect mismapping » décrit une méthode utilisant les données de tension et de position géographique d'un compteur afin de corriger la topologie d'un réseau de basse-tension. Cette méthode ne traite que les cas d'erreurs de localisation de compteurs rapprochés géographiquement. Or, lors d'une inscription compteur dans la base de données, une erreur d'entrée de nom de transformateur mène à un transformateur qui peut être localisé n'importe où sur le réseau, y compris sur une autre ligne. Cette méthode est sensible aux erreurs présentes dans la base de donnée géomatique (localisation du compteur, localisation du transformateur et adresse du lieu de consommation). La méthode propose une métrique d'erreur de rattachement (« mismapping metric ») qui est fonction des corrélations individuelles des compteurs alloués à un transformateur avec le compteur sélectionné. Dans le cas souvent observé où, pour un transformateur donné il y a plus d'une erreur de rattachement de compteurs, une partie de la comparaison calculée pour le compteur sélectionné se fera avec des corrélations individuellement réalisées sur un ou des compteurs qui ne sont pas rattachés au transformateur.

**Sommaire**

Selon un aspect de l'invention, il est proposé une méthode par système informatique de correction automatique d'une topologie d'un réseau de distribution électrique définie par des attributions respectives de compteurs à des transformateurs, la méthode comprenant les étapes de:

(i) pour chaque transformateur de la topologie, partager les compteurs attribués au transformateur en des premier et deuxième lots selon un critère de partage et un degré de similarité des enregistrements de tensions mesurées par les compteurs par rapport à une tension moyenne évaluée avec les enregistrements de tensions mesurées par les compteurs attribués au transformateur de manière que le premier lot comprenne les compteurs dont le degré de similarité est plus élevé que les compteurs du deuxième lot;

(ii) initialement pour chaque transformateur de la topologie puis subséquemment pour chaque transformateur dont l'attribution de compteurs a changé, calculer une tension moyenne corrigée avec les enregistrements de tensions mesurées par les compteurs uniquement dans le premier lot du transformateur;

(iii) calculer une similarité des enregistrements de tensions mesurées des compteurs dans les deuxièmes lots des transformateurs avec les tensions moyennes corrigées des transformateurs calculées en (ii);

(iv) pour chaque transformateur de la topologie, déterminer quels sont, dans le deuxième lot, les compteurs attribuables à un autre transformateur selon les similarités calculées en (iii);

(v) réattribuer au moins un des compteurs déterminés en (iv); et

(vi) tant qu'un compteur a été réattribué en (v), répéter les étapes (ii) à (v),

la topologie étant corrigée lorsqu'il ne reste plus de compteurs attribuables à d'autres transformateurs dans les deuxièmes lots.

Selon un autre aspect de l'invention, il est proposé une méthode pour évaluer une résistance de raccordement d'un compteur à un transformateur de distribution auquel d'autres compteurs sont raccordés, comprenant les étapes de:

obtenir des enregistrements de tensions et de consommations de chaque compteur raccordé au transformateur de distribution; et

évaluer la résistance de raccordement $R_i$ du compteur par un rapport de sommes de dérivées discrètes selon l'équation suivante:

$$R_i = -\frac{\sum_{n=2}^{N}\left(\partial v_{i,n} - \partial v_{k,n}\right)\cdot \partial c_{i,n}}{\sum_{n=2}^{N}\left(\partial c_{i,n}\right)^2}$$

où $i$ représente un indice du compteur parmi tous les compteurs, $n$ représente un intervalle temporel parmi une durée couvrant $N$ enregistrements de tensions v et de consommations c du compteur $i$, $k$ représentant un indice du transformateur de distribution parmi d'autres transformateurs de distribution, la tension $v_{k,n}$ étant une tension moyenne évaluée avec les enregistrements de tensions de tous les compteurs pour l'intervalle n.

Selon un autre aspect de l'invention, il est aussi proposé un système informatique de correction automatique d'une topologie d'un réseau de distribution électrique définie par des attributions respectives de compteurs à des transformateurs, le système informatique comprenant au moins un dispositif de stockage d'une base de données topologiques représentant la topologie du réseau de distribution électrique, au moins un dispositif de stockage d'enregistrements de tensions mesurées par les compteurs, et une unité de traitement ayant une interface pour communiquer avec les dispositifs de stockage, au moins un processeur et une mémoire stockant des instructions exécutables par le processeur et configurant l'unité de traitement pour effectuer les étapes de:

(i) pour chaque transformateur de la topologie, partager les compteurs attribués au transformateur en des premier et deuxième lots selon un critère de partage et un degré de similarité des enregistrements de tensions mesurées par les compteurs par rapport à une tension moyenne évaluée avec les enregistrements de tensions mesurées par les compteurs attribués au transformateur de manière que le premier lot comprenne les compteurs dont le degré de similarité est plus élevé que les compteurs du deuxième lot;

(ii) initialement pour chaque transformateur de la topologie puis subséquemment pour chaque transformateur dont l'attribution de compteurs a changé, calculer une tension moyenne corrigée avec les enregistrements de tensions mesurées par les compteurs uniquement dans le premier lot du transformateur;

(iii) calculer une similarité des enregistrements de tensions mesurées des compteurs dans les deuxièmes lots des transformateurs avec les tensions moyennes corrigées des transformateurs calculées en (ii);

(iv) pour chaque transformateur de la topologie, déterminer quels sont, dans le deuxième lot, les compteurs attribuables à un autre transformateur selon les similarités calculées en (iii);

(v) réattribuer au moins un des compteurs déterminés en (iv) et mettre à jour la base de données topologiques suivant une nouvelle attribution de l'au moins un des compteurs; et

(vi) tant qu'un compteur a été réattribué en (v), répéter les étapes (ii) à (v),

la topologie étant corrigée lorsqu'il ne reste plus de compteurs attribuables à d'autres transformateurs dans les deuxièmes lots.

Ce qui suit fournit un aperçu de certaines caractéristiques possiblement préférables de l'invention qui doivent être considérées non limitativement et qui seront décrites plus en détail ci-après.

La méthode selon l'invention exploite l'information contenue dans des mesures de tension collectées par des compteurs intelligents afin de déterminer quel compteur est rattaché à quel transformateur. Selon une réalisation de l'invention, la méthode démarre d'une topologie initiale qui comporte potentiellement des erreurs d'attribution de compteur à transformateur et réalise des réattributions successives jusqu'à ce que chaque compteur soit attribué au réseau d'un transformateur pour lequel la tension du compteur a le plus de similarité avec la tension moyenne de ce réseau. De préférence, une réalisation de calcul de similarité est une fonction de la distance entre deux séries temporelles de tension exprimées dans un espace multidimensionnelle, ou de la corrélation entre ces séries, ou une combinaison de la distance et de la corrélation, et une contribution possible de séries temporelles de consommation. Les séries temporelles de consommation peuvent être utilisées pour corriger la distance et aussi pour alimenter une fonction d'aiguillage des données entre le calcul de la distance et le calcul de la corrélation. Le calcul de similarité peut recourir à une estimation de la résistance apparente de raccordement du compteur en validation. Cette estimation peut signaler la présence d'une non-conformité électrique (NCE) lorsque la valeur de la résistance de raccordement est à l'extérieur d'une plage de valeurs plausibles, soit trop petite ou trop grande par rapport à celles observées pour les autres compteurs. En résumé, la méthode selon l'invention peut comprendre les étapes successives de séparer en deux lots les compteurs attribués à un transformateur selon le degré de similarité de chaque compteur avec les autres compteurs de sorte qu'un lot comprends les compteurs dits « immuables » car ils sont similaires à l'ensemble alors que le second lot comprend les compteurs dits « mobiles » car ils sont moins similaires, de calculer une tension moyenne corrigée par transformateur à partir du lot de compteurs immuables, de calculer la similarité des compteurs mobiles de tous les transformateurs avec la tension moyenne corrigée de chaque transformateur, de trouver pour chaque transformateur quels sont les compteurs mobiles susceptibles d'être réattribués, de sélectionner pour chaque transformateur où il y a au moins un compteur à réattribuer lequel sera priorisé si voulu, de réattribuer au moins un compteur et, s'il reste des compteurs mobiles susceptibles d'être réattribués, de retourner à l'étape de séparation en lots de compteurs immuables et mobiles, de réaliser cette étape pour les transformateurs qui ont eu une réattribution de compteurs et de réaliser une nouvelle itération en poursuivant les étapes suivantes, sinon, les réattributions sont terminées.

Un avantage de la méthode selon l'invention est que contrairement aux méthodes de l'art où il est requis de comparer $I$ compteurs avec $I$-1 compteurs, pour un total de $I(I$-1) opérations, la méthode selon l'invention compare $I$ compteurs avec $K$ transformateurs, de sorte que l'effort de calcul est réduit et la précision est accrue puisque la tension moyenne de chaque transformateur calculée à partir des compteurs les plus similaires entre eux est une valeur plus fiable puisque les compteurs « mobiles » reliés potentiellement à un autre transformateur ne contribuent pas à ce calcul. Le résultat de la mise à jour donne l'historique des déplacements de compteurs et de cet historique on peut extraire une topologie correspondant à un moment donné.

Un autre avantage de la méthode selon l'invention est qu'elle ne requière pas de données de géolocalisation ni de dispositifs de mesure sur les transformateurs ou sur le départ de ligne moyenne-tension dans un poste de transformation.

## Description brève des dessins

FIG. 1 illustre un exemple de schéma unifilaire d'une portion d'arborescence partant d'une phase haute-tension (HT) et alimentant une ligne moyenne-tension reliée à deux transformateurs moyenne à basse-tension auxquels sont rattachés plusieurs compteurs de consommateurs.

FIG. 2 illustre un réseau d'impédances équivalent à une portion d'arborescence monophasée reliant deux compteurs rattachés à des transformateurs de moyenne à basse-tension différents et où l'un des compteurs transite une variation de charge se reflétant par une modulation de courant $c_i$ qui est observée comme une variation de tension $v_i$ par un autre compteur.

FIG. 3 illustre une représentation multidimensionnelle de séries-tensions de compteurs rattachés à une ligne, avec les séries-tensions pour chaque transformateur et pour la ligne.

FIG. 4 illustre une représentation multidimensionnelle d'une comparaison entre la corrélation et la distance pour une série-tensions mesurées par un compteur et comparée aux séries-tensions calculées pour deux transformateurs où $t_1$ est celui avec lequel le compteur est raccordé.

FIG. 5 est un diagramme schématique illustrant les principales étapes d'une réalisation de la méthode selon l'invention, dite optimale de réattribution successive des compteurs aux transformateurs auxquels ils sont rattachés.

FIG. 6A illustre une représentation multidimensionnelle de séries-tensions de compteurs rattachés à un transformateur, avec la série-tension de ce transformateur et où la série-tension d'un compteur varie bien davantage que celle des autres compteurs en raison d'une charge significative transitée par ce compteur.

FIG. 6B illustre une représentation multidimensionnelle pour des dérivées discrètes de séries-tensions avec un exemple de correction de la série-tension d'un compteur dit bruyant.

FIG. 7 illustre une représentation multidimensionnelle de tensions de compteurs rattachés à un transformateur, avec au centre la série-tension de ce transformateur et où un ensemble des compteurs dits immuables est circonscrit par une hypersphère représentée par le cercle intérieur en pointillés, l'ensemble de tous les compteurs censés être rattachés au transformateur étant représenté par le cercle extérieur en pointillés pouvant inclure ou non la représentation de la série-tension d'un compteur en validation.

FIG. 8 est un diagramme illustrant une réalisation de l'étape 108 de la FIG. 5 qui minimise un temps de calcul.

FIGS. 9A, 9B et 9C illustrent respectivement des exemples d'un histogramme de consommation pour un compteur, d'un histogramme de consommation totale comprenant la somme des consommations de tous les compteurs rattachés à un transformateur, et d'un histogramme de la consommation relative d'un compteur par rapport à la consommation totale où sont mis en noir l'intersection des ensembles de coïncidences statistiques telle à droite « compteur bruyant » ∩ « réseau silencieux » et à gauche « comteur silencieux » ∩ « réseaux bruyant ».

FIG. 10 est un diagramme schématique illustrant une sélection de segments par une méthode différentielle pour déterminer et localiser un déplacement de compteur d'un transformateur $k$ vers un transformateur $l$ où est présentée la superposition des trois plages temporelles possibles d'occurrence d'un tel déplacement.

FIG. 11 est un diagramme schématique illustrant des étapes d'une méthode d'estimation d'une position temporelle qui correspond au moment d'un déplacement d'un compteur entre deux transformateurs.

FIG. 12 est un diagramme schématique illustrant un système exécutant la méthode selon une réalisation de l'invention.

## Description détaillée des réalisations préférées

La méthode selon l'invention permet de mettre à jour une base de données décrivant l'appariement compteur-transformateur d'un réseau basse-tension. Les données utilisées pour établir une mise à jour sont :

- une base de données contenant les liens d'attribution compteur-transformateur et pouvant comporter une certaine proportion d'erreurs d'attribution,
- des mesures de tensions et préférablement de consommation des compteurs indexées en fonction d'une identité du compteur et possiblement horodaté avec une estampille temporelle.

La topologie du réseau de distribution électrique comprend au minimum les liens d'attribution compteur-transformateur. Ces liens peuvent être disponibles sous différentes formes d'indexation, avec ou sans horodatage des déplacements de compteurs et des ajouts de nouveaux compteurs et transformateurs.

Les mesures de tension peuvent être de différentes natures, par exemple : efficace (RMS) instantanée, tension efficace moyenne entre deux estampilles temporelles, tension efficace moyenne pour une durée donnée. Les mesures de consommations seront typiquement exprimées en kilowattheures (kWh) cumulés entre deux estampilles temporelles. Il est souhaitable que ces mesures soient horodatées, ou, à tout le moins, disponibles par ordre temporelle de lecture.

La mesure de consommation d'énergie d'un compteur est en bonne partie indépendante des autres événements survenant sur le réseau. Cette mesure de consommation, sommées pour les compteurs intelligents que l'on pense rattachés à un transformateur, représente une partie de la charge de ce transformateur, l'autre partie étant les compteurs non-communicants, les rattachements forfaitaires (ex. : éclairage de ville sans compteur) et la subtilisation d'énergie.

Dans une réalisation de la méthode selon l'invention, la partie réactive de l'impédance est négligée en considérant le facteur de puissance comme unitaire, puisque souvent les mesures correspondantes ne sont pas acheminées à la base de données. Cependant, dans une réalisation possible de la méthode selon l'invention, la partie réactive peut être considérée pour améliorer la vraisemblance des corrections proposées en l'introduisant comme variable d'entrée dans les formulations qui suivent.

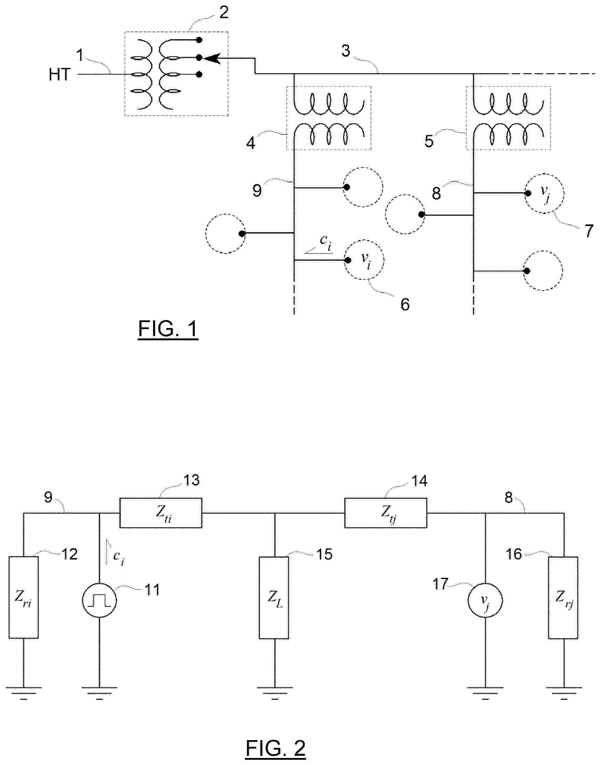

En référence à la Figure 1, les fluctuations de tension attribuables au réseau haute-tension **1** et aux changements de prises du transformateur **2** alimentant la ligne moyenne-tension **3** constituent une source de bruit commune à tous les transformateurs **4, 5** reliés à la même ligne **3** ainsi que les compteurs **6, 7** qui y sont rattachés. Non seulement cette fluctuation est commune mais elle est d'une amplitude similaire pour tous les compteurs puisque la diminution relative, par rapport à la tension du réseau, de son amplitude suit la chute relative de tension du réseau avec l'éloignement des compteurs par rapport au transformateur **2**. Nous verrons plus loin comment la méthode selon l'invention est insensible aux fluctuations de tension communes à tous les compteurs.

D'autre part, une commutation de charge d'un consommateur entraîne une fluctuation de courant qui, du fait de l'impédance du réseau, sera perçue comme une fluctuation de tension par tout compteur rattaché de près ou de loin sur ce réseau. Cette fluctuation de tension générée par la commutation d'une charge sur le réseau est atténuée entre le lieu de commutation et la localisation du compteur **7** qui mesure la fluctuation de tension correspondante. Ces fluctuations de tension peuvent servir à déterminer un degré de similarité entre deux compteurs. Par exemple, si un compteur est situé dans un même bâtiment à quelques centimètres d'un compteur qui transite la charge commutée, ces deux compteurs verront presque la même fluctuation de tension. En référence aussi à la Figure 2, à l'opposé, si un compteur **7** qui est situé sur le réseau **8** du transformateur voisin **5** du compteur **6** qui transite la commutation de charge mesure la tension **17**, la fluctuation de courant **11** sera atténuée par un diviseur constitué par le réseau formé par les impédances des transformateurs **13, 14**, les impédances des réseaux **12, 16** alimentés par les transformateurs et de la ligne **15**. Le réseau agit alors comme un filtre d'atténuation qui typiquement réduit d'un ordre de grandeur à deux ordres de grandeur l'amplitude d'une fluctuation transitant d'un réseau de basse tension **9** à l'autre **8**.

En ce qui concerne des compteurs rattachés à un même transformateur, discutons de deux cas extrêmes de localisation de compteur, soit le compteur qui a le raccordement le plus proche du transformateur et celui qui a le raccordement le plus éloigné du transformateur. Pour une même charge commutée, le compteur qui a le raccordement le plus éloigné impactera davantage la tension de tous les compteurs qui sont situés entre lui et le transformateur, alors que le compteur qui a le raccordement le plus proche impactera à une même grandeur minimale l'ensemble des compteurs. À ce stade, pour des compteurs rattachés à un même transformateur, retenons que la variation de tension perçue par les compteurs est fonction de la position du compteur opérant la commutation de charge et de la position du compteur enregistrant la variation de tension.

Notons que le cas d'un réseau où des clients monophasés sont rattachés à des clients alimentés en triphasés est plus complexe que le circuit monophasé décrit plus haut et illustré aux Figures 1 et 2. En effet, d'une part, les impédances phase-phase des équipements triphasés permettent un transfert des fluctuations de tension d'une phase à l'autre et d'autre part, ces équipements génèreront des variations de charge commune aux trois phases augmentant la difficulté d'attribution d'un compteur monophasé à une phase donnée. Cependant, le résonnement précédent tout comme les développements qui suivent restent applicables.

Que ce soit dans la recherche d'un maximum de similarité ou la recherche d'un minimum de dissimilitude, la finalité est la même. Dans ce qui suit, aux termes similaire et similitude pourront correspondre respectivement les termes dissimilaire et dissimilitude, avec inversion des termes d'optimisation telle la maximisation ou la minimisation.

Soit

$$v_{L,n} = \frac{1}{\sum_{i \in \mathbf{L}} 1} \cdot \sum_{i \in \mathbf{L}} v_{i,n} \tag{1}$$

la série discrète de tension moyenne instantanée de la ligne correspondant à la moyenne instantanée des tensions de tous les compteurs $i$ rattachés à une ligne $L$, où $\mathbf{L}$ est l'ensemble des indices des compteurs rattachés à la ligne $L$, et pour lesquels nous disposons des mesures de tensions $v_{i,n}$ et ce pour l'estampille temporelle d'indice n.

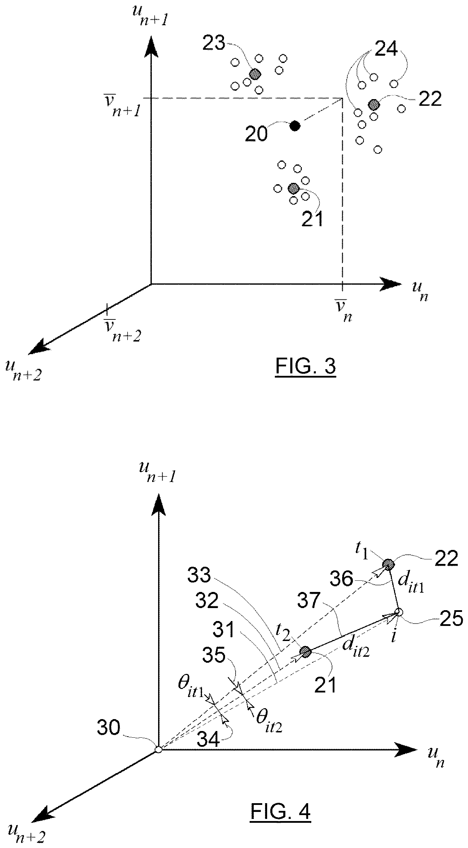

En référence à la Figure 3, représentons dans un espace multidimensionnel $R^N$ cette tension moyenne pour $N$ estampilles temporelles où les $u_n$ sont les axes de tension. Cette tension moyenne apparaît alors tel un point **20** dans cet espace.

Soit

$$v_{k,n} = \frac{1}{\sum_{i \in \mathbf{T}_k} 1} \cdot \sum_{i \in \mathbf{T}_k} v_{i,n} \tag{2}$$

la série temporelle discrète de la tension moyenne instantanée de l'un des transformateurs reliés à la ligne moyenne tension où $\mathbf{T}_k$ est l'ensemble des indices des compteurs rattachés au transformateur $k$. Représentés en multidimensionnel, les séries temporelles discrètes de la tension moyenne instantanée associées aux différents transformateurs apparaîtrons comme des points **21, 22, 23**. Chacun de ces points sera situé au centre de masse d'un nuage constitué des tensions des compteurs **24** rattachés au transformateur correspondant **22**.

Soit une corrélation définie comme le produit de corrélation centrée (Pearson)

$$\gamma_{i,j} = \frac{\sum_{n=1}^{N} \left( v_{i,n} - \overline{v}_i \right) \cdot \left( v_{j,n} - \overline{v}_j \right)}{\sqrt{\sum_{n=1}^{N} \left( v_{i,n} - \overline{v}_i \right)^2 \cdot \sum_{n=1}^{N} \left( v_{j,n} - \overline{v}_j \right)^2}} \tag{3}$$

avec les moyennes temporelles discrètes de tensions

$$\overline{v}_i = \frac{1}{N}\sum_{n=1}^{N} v_{i,n} \quad \text{et} \quad \overline{v}_j = \frac{1}{N}\sum_{n=1}^{N} v_{j,n} \tag{4}$$

où $v_{i,n}$ et $v_{j,n}$ sont deux séries d'enregistrements de tensions comparées avec n pour indice temporel. Soit la distance

$$d_{i,j} = \sqrt{\sum_{n=1}^{N}\left(v_{i,n} - v_{j,n}\right)^2} \tag{5}$$

entre deux séries d'enregistrements de tensions comparées avec n pour indice temporel. Pour les relations 3 et 5 la comparaison peut s'exercer entre deux compteurs, entre un compteur et la tension moyenne instantanée calculée pour un transformateur ou même entre la tension moyenne instantanée de la ligne et celle d'un transformateur.

Une série d'enregistrements peut par exemple comprendre de quelques heures à quelques mois d'enregistrements. La durée correspondante peut être plus courte si les enregistrements sont rapprochés, par exemple aux 5 ou 15 minutes plutôt qu'aux heures.

En représentation multidimensionnelle des séries temporelles discrètes de la tension mesurée (ou mesures de tensions), les points correspondants aux compteurs les plus éloignés du transformateur seront plus rapprochés de l'origine (0,0,...) alors que ceux correspondants aux compteurs les plus rapprochés ayant une tension en moyenne plus élevée seront situés plus éloignés de l'origine par rapport au point correspondant à la tension moyenne de tous les compteurs.

Une réalisation préférée de la méthode selon l'invention exploite les dérivées discrètes de tension plutôt que la tension de manière à ce que la méthode soit moins sensible aux changements de tension de longue période communes à tous les compteurs et aussi moins sensible aux erreurs systématiques attribuables aux écarts d'étalonnage en les compteurs. Comme il est possible d'exploiter la méthode avec les tensions comme avec les dérivées de tension, pour la suite de la divulgation, l'expression « série temporelle discrète de mesures de tension » pourra aussi correspondre à « série temporelle discrète de la dérivée des mesures de tension », sauf mention expresse. Par contre, là où apparaîtra des dérivées de tension (dans les expressions mathématiques, dans le texte et les figures), celles-ci ne devront pas être substituées par des tensions. Aussi, afin d'alléger le texte, le terme série-tension sera utilisé pour désigner une série temporelle discrète de tension. Dans le cas d'un compteur, cela correspondra à une série temporelle discrète de la tension mesurée par le compteur. Dans le cas d'un transformateur, cela correspondra à une série temporelle discrète de tension moyenne instantanée calculée pour le transformateur alors que dans le cas d'une ligne, cela correspondra à une série temporelle discrète de tension moyenne instantanée calculée pour la ligne.

En référence à la Figure 4, il est illustré une représentation multidimensionnelle d'une comparaison entre la série-tension du compteur $i$ et les séries-tensions calculées aux transformateurs $t1$ et $t2$. Le coefficient de corrélation entre la série-tension mesurée par le compteur **25** et la série-tension du transformateur $t_1$ **22** auquel il est raccordé correspond au cosinus de l'angle **34** entre deux vecteurs, un vecteur **31** reliant l'origine **30** et la série-tension mesurée par le compteur **25** et l'autre vecteur **33** reliant l'origine **30** et la série-tension calculée pour $t_1$ **22**. Le coefficient de corrélation entre la série-tension mesurée par le compteur **25** et la série-tension du transformateur $t_2$ **21** correspond au cosinus de l'angle **35** entre deux vecteurs, un vecteur **31** reliant l'origine **30** et la série-tension mesurée par le compteur **25** et l'autre vecteur **32** reliant l'origine **30** et la série-tension calculée pour $t_2$ **21**. On constate dans cet exemple que la série-tension du compteur corrèle davantage avec celle du transformateur $t_2$ **21** qu'avec celle du transformateur $t_1$ **22** auquel il est raccordé. Par contre, la distance $d_{it1}$ **36** entre la série-tension du compteur **25** et celle du transformateur $t_1$ **22** auquel il est raccordé est moindre que la distance $d_{it2}$ **37** entre la série-tension du compteur **25** et celle du transformateur $t_2$ **21**.

Pour améliorer la corrélation, ou peut imaginer de soustraire la série-tension calculée pour la ligne. La série-tension de la ligne $v_{L,n}$ est une tension significative de la tension de la source de puissance alimentant tous les compteurs de cette ligne. Si l'on soustrait la série-tension $v_{L,n}$ des séries-tensions mesurées par les deux compteurs dans l'équation 2, tel que $v_{i,n}-v_{L,n}$ et $v_{j,n}-v_{L,n}$ remplace respectivement $v_{i,n}$ et $v_{j,n}$, cela donne

$$\gamma'_{i,j} = \frac{\displaystyle\sum_{n=1}^{N}\left(v_{i,n} - v_{L,n} - \overline{v}_i + \overline{v}_L\right)\cdot\left(v_{j,n} - v_{L,n} - \overline{v}_j + \overline{v}_L\right)}{\sqrt{\displaystyle\sum_{n=1}^{N}\left(v_{i,n} - v_{L,n} - \overline{v}_i + \overline{v}_L\right)^2 \cdot \sum_{n=1}^{N}\left(v_{j,n} - v_{L,n} - \overline{v}_j + \overline{v}_L\right)^2}} \tag{6}$$

Soit,

$$\gamma'_{i,j} \cong \frac{\sum_{n=1}^{N}\left(v_{i,n}-\overline{v}_i\right)\cdot\left(v_{j,n}-\overline{v}_j\right)-\sigma_L^2}{\sqrt{\left(\sum_{n=1}^{N}\left(v_{i,n}-\overline{v}_i\right)^2-\sigma_L^2\right)\cdot\left(\sum_{n=1}^{N}\left(v_{j,n}-\overline{v}_j\right)^2-\sigma_L^2\right)}} \qquad (7)$$

après manipulation algébrique, en supposant que les variations de tension de ligne ne sont pas corrélées avec les variations induites par les charges, et avec

$$\sigma_L^2 = \sum_{n=1}^{N}\left(v_{L,n}-\overline{v}_L\right)^2 \qquad (8)$$

comme le carré de la dispersion quadratique de la tension de ligne. D'un point de vue géométrique dans l'espace multidimensionnel $R^N$, le retrait du vecteur $\mathbf{V}_L \equiv [v_{L,1}, v_{L,2},...,v_{L,N}]$ des vecteurs $\mathbf{V}_i \equiv [v_{i,1}, v_{i,2}]$ et $\mathbf{V}_j \equiv [v_{j,1}, v_{j,1},...,v_{j,N}]$ correspond à une translation des points pointés par ces deux vecteurs. Cette translation modifie les valeurs de corrélation sans rapprocher ou distancer ces points. Une décision basée sur la corrélation pourra être modifiée par une translation alors qu'une décision basée sur la distance est indépendante de la translation. On conclut que le résultat de la corrélation est impacté par la grandeur de la série $V_L$ de tensions de ligne qui apparaît commune dans les réseaux, ce qui n'est pas le cas pour un calcul de distance.

En référence à nouveau à la Figure 2, vu autrement par le biais d'un exemple pratique, soit une manipulation de charge **11** éloignée d'un point de mesure **17**, s'il n'y a pas d'autre manipulation de charge sur le réseau alors le point de mesure **17** pourra observer cette fluctuation avec une corrélation parfaite entre la tension mesurée par compteur 11 qui transite cette fluctuation et le compteur 17 qui mesure à distance. Par contre, s'il y de nombreuses modulations de charge distribuées sur le réseau, celles-ci génèreront des fluctuations de tension qui s'additionneront à la mesure de tension prise par les compteurs. Ces fluctuations feront en sorte que la tension mesurée à distance **17** corrèlera moins avec la tension mesurée là où se produit la manipulation de charge **11.** Il existe des contextes où la grandeur de corrélation n'est pas une caractéristique fiable comme indice de similarité entre deux compteurs ou entre un compteur et la tension moyenne calculée pour un transformateur. Il suffit qu'il y ait un silence sur la ligne au moment d'une modulation de charge transitée par un compteur pour que ce dernier soit perçu comme similaire pour beaucoup d'autres points de mesure. Comme moyen de calcul de la similarité, maximiser la corrélation n'équivaut pas à minimiser la distance et peut mener à une décision erronée. C'est une des faiblesses des méthodes proposées dans les demandes US 2015/0241482 (Sonderegger) et US 2016/0131501 (Steigler). Dans le développement qui suit, nous proposons d'ajouter l'optimisation de la distance à la fonction de similarité.

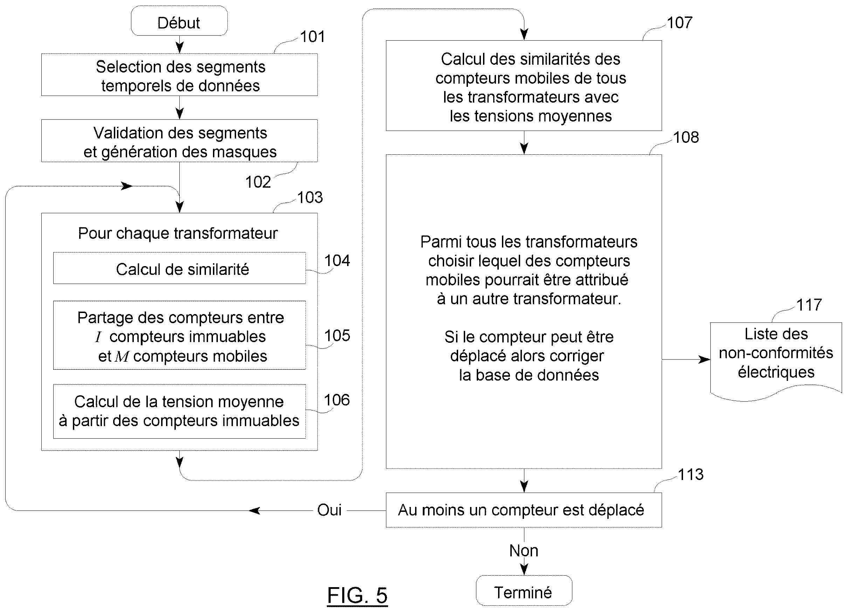

En référence à la Figure 5, une réalisation de la méthode selon l'invention procède par une sélection des segments temporels de données **101** disponibles dans une base de données dans un dispositif de stockage central **301** ou dans un ou plusieurs dispositifs de stockage distribués ou non dans le réseau de compteurs **300,** par exemple lorsque les compteurs sont dotés de fonctionnalités pour stocker les mesures ou enregistrements formant les données. Cette étape de sélection détermine une plage temporelle considérée pour le calcul de similarité. Selon une réalisation préférée de la méthode, pour détecter un déplacement de compteur, la sélection comprends au moins deux segments temporels successifs. Une étape de validation des segments **102** génère un masque qui sera un attribut de chaque compteur ou regroupement de compteurs. Dans cette étape, les pannes et anomalies sont détectées afin de rejeter les enregistrements temporels correspondants. Les pannes sont communes à un transformateur ou plusieurs transformateurs alors que les anomalies peuvent concerner un seul client. Dans le cas d'une anomalie détecté pour un seul client, typiquement ce sera un patron anormal correspondant à des chutes de tensions significatives non observées sur les autres compteurs et possiblement généré par une défectuosité de raccordement. Par la suite, pour chaque opération de calcul, les masques seront combinés en intersection de façon à ne traiter que les données simultanément valides pour tous les intrants de l'opération.

Comme illustré par le bloc **103,** il s'agit pour chaque transformateur de calculer la similarité **104** entre les compteurs qui sont rattachés à un même transformateur. Soit, par exemple, la fonction de similarité S estimant une similarité

$$s_{i,k} = S\left(\mathbf{v}_i : \left\{\mathbf{v}_{j_1}, \mathbf{v}_{j_2}, ..., \mathbf{v}_{j_v}, ...\right\}\Big|_{j_v \in T_k}\right) \qquad (9)$$

entre le vecteur de tension $\mathbf{v}_i$ correspondant au compteur $i$ et les vecteurs de tension $\mathbf{v}_{jy}$ des autres compteurs rattachés au transformateur $k$ où une série-tension d'un compteur correspond au vecteur tension

$$\mathbf{v}_z \equiv \left[ v_{z,1}, v_{z,2}, \ldots v_{z,n}, \ldots v_{z,N} \right] \text{ avec } z \in \left\{ i, j_1, j_2, \ldots \right\} , \tag{10}$$

$n$ étant l'indice temporel des enregistrements. Les compteurs reliés au transformateur $k$ ou un sous-ensemble de ces compteurs participent à l'estimé formulée à l'équation 9.

En référence à nouveau à la Figure 3, une fonction de similarité basée sur la distance peut prendre différentes formulations. Par exemple, pour chaque compteur $i$ on réalise la somme quadratique des distances que sa série-tension a avec celles des autres compteurs rattachés au même transformateur $k$ telle que

$$s_{i,k} = \sqrt{\frac{1}{\sum_{j \in \mathbf{T}_k} 1} \cdot \sum_{j \in \mathbf{T}_k} d_{i,j}^2} \text{ avec } d_{i,j} = \sqrt{\sum_{n=1}^{N} \left( v_{i,n} - v_{j,n} \right)^2} \tag{11a}$$

ou encore la somme des distances (possiblement moins précis) telle que

$$s_{i,k} = \frac{1}{\sum_{j \in \mathbf{T}_k} 1} \cdot \sum_{j \in \mathbf{T}_k} d_{i,j} . \tag{11b}$$

ou encore, selon une réalisation préférée de la méthode,

$$s_{i,k} = \sqrt{\sum_{n=1}^{N} \left( v_{i,n} - v_{k,n} \right)^2} \tag{11c}$$

où la tension $v_{k,n}$ est la série-tension du transformateur $k$ telle que calculée à l'équation 2. Notons que l'expression 11c tend vers zéro lorsque le point de représentation multidimensionnel correspondant à un compteur tend à se superposer à celui du transformateur **22,** alors que 11a et 11b tendent vers une grandeur non nulle qui est fonction de la dispersion des compteurs **24** autour du transformateur **22.**

En référence à nouveau à la Figure 5, on regroupe la similarité calculée pour chaque compteur rattaché à un transformateur dans le vecteur de similarité

$$\mathbf{S}_k = \left[ \cdots \quad s_{i,k} \quad \cdots \right] . \tag{12}$$

Ce vecteur sera utilisée dans l'étape **105** du partage des compteurs entre $U_k$ compteurs immuables (« Unchangeable ») qui s'apparentent le plus, et $C_k$ compteurs mobiles (« Changeable ») de sorte que

$$U_k = \sum_{i_k \in \mathbf{U}_k} 1 \text{ et } C_k = \sum_{i_k \in \mathbf{C}_k} 1 \tag{13}$$

avec $\mathbf{U}_k \cup \mathbf{C}_k = \mathbf{T}_k$ et $U_k + C_k = T_k$, c'est-à-dire que l'union des ensembles des compteurs immuables et des compteurs mobiles correspond à l'ensemble des compteurs rattachés au transformateur $k$ selon la description topologique initiale. Le nombre de compteurs mobiles peut être un nombre fixe ou, selon une réalisation préférée de la méthode, donné dans une proportion déterminée du nombre de compteurs rattachés au transformateur. Selon la réalisation préférée, le paramètre de traitement

$$\alpha = \frac{U_k}{T_k} \tag{14}$$

fixe le rapport du nombre de compteurs immuables $U_k$ sur le nombre total de compteurs $T_k$. Typiquement mais non limitativement, le ratio $\alpha$ est fixé à 30% avec un minimum de un compteur mobile à partir d'une population de trois compteurs et plus assignés à un transformateur. Soulignons que $U_k = 1$ et $C_k = 0$ dans le cas d'un transformateur qui n'a qu'un seul compteur qui lui est rattaché. En pareil cas, on considérera que le compteur est immuable. Une réalisation préférée de la méthode réalisera un tri des $s_{i,k}$ éléments de $\mathbf{S}_k$ par ordre décroissant de similarité et classera comme immuables les $U_k$ premiers éléments. Comme illustré au bloc **106**, un calcul de la série-tension corrigée attribuée à un transformateur

$$v_{k,n}^{U} = \frac{1}{U_k} \cdot \sum_{i \in \mathbf{U}_k} v_{i,n} \tag{15}$$

est effectué à partir des séries-tensions des $U_k$ compteurs immuables. De la sorte, on s'assure que les compteurs éloignés **28** du nuage constitué des séries-tensions de compteurs raccordés au transformateur et qui, possiblement, peuvent ne pas être reliés au transformateur ne participe pas à ce calcul de série- tension corrigée. Pour le cas d'un capteur mobile qui est à valider par rapport à son transformateur d'origine, ce calcul permet ne pas considérer la série-tension du compteur à valider dans le calcul de la série-tension du transformateur. Sans cette exclusion, pour un réseau comprenant $I$ compteurs, il y aurait en avantage pour ce choix de rattachement compteur-transformateur une proportion de $1/I$ qui refléterait le poids relatif de la tension du compteur en validation par rapport aux autres compteurs.

La série-tension corrigée de chaque transformateur est utilisée pour réaliser le calcul des similarités telles que, selon une réalisation préférée de la méthode,

$$\mathbf{S}_k^{U} = \begin{bmatrix} \cdots & s_{i,k}^{U} & \cdots \end{bmatrix}, \text{ avec } s_{i,k}^{U} = \sqrt{\sum_{n=1}^{N} \left( v_{i,n} - v_{k,n}^{U} \right)^2}. \tag{16}$$

Étendons l'usage de l'ensemble des compteurs immuables au calcul de la corrélation entre un compteur mobile $i$ et un transformateur $k$ tel que

$$\gamma_{i,k}^{U} = \frac{\sum\limits_{n=1}^{N} \left( v_{i,n} - \overline{v}_i \right) \cdot \left( v_{k,n}^{U} - \overline{v}_k^{U} \right)}{\sqrt{\sum\limits_{n=1}^{N} \left( v_{i,n} - \overline{v}_i \right)^2 \cdot \sum\limits_{n=1}^{N} \left( v_{k,n}^{U} - \overline{v}_k^{U} \right)^2}} \tag{17}$$

avec

$$\overline{v}_k^{U} = \frac{1}{N} \sum_{n=1}^{N} v_{k,n}^{U}. \tag{18}$$

Soulignons que les perturbations de tension occasionnées par une subtilisation d'énergie ou la présence d'un compteur non-communicant ne nuisent pas à la méthode. Au contraire, dans $R^N$ (Figure 3), elles augmentent la distance et réduisent la corrélation qu'a le transformateur sur lequel s'effectue la consommation sans mesurage avec les autres transformateurs.

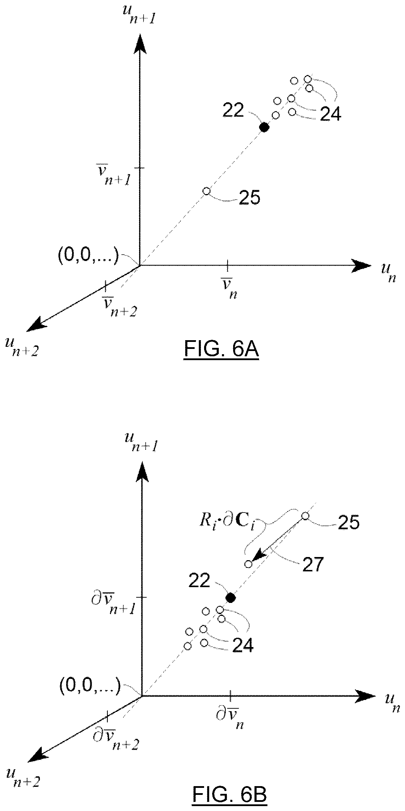

Cette dernière fonction de similarité fondée sur la distance donne d'excellents résultats lorsque le compteur transite une faible charge (une charge qui varie peu dans le temps dans le cas de la dérivée en tension) en comparaison des autres compteurs. Dans la situation opposée, soit lorsque le compteur transite une charge significatives (une charge qui varie beaucoup dans le temps dans le cas de la dérivée en tension) en comparaison des autres compteurs, la tension de ce compteur s'éloigne de la tension moyenne instantanée du transformateur. Si nous prenons le cas extrême d'un seul compteur qui transite des charges significatives en comparaison des autres compteurs, la représentation multidimensionnelle illustrée à la Figure 3 est remplacée par celle de la Figure 6A à laquelle il est maintenant fait référence et où les points associés aux séries-tensions compteurs et le point associé à la série-tension du transformateur sont approximativement colinéaires entre eux. Dans ce cas limite, le point correspondant au compteur qui transite des charges significatives est le seul qui se retrouve à l'opposé des autres compteurs par rapport au point associé à la série-tension du transformateur. Dans une représentation multidimensionnelle des séries-tensions, le point correspondant au compteur qui transite des charges significatives se rapproche de l'origine (0,0,...) alors que pour une représentation multidimensionnelle des dérivées de séries-tensions comme illustré à la Figure 6B, ce point s'éloigne de l'origine. Soulignons que, par rapport au point associé à la tension du transformateur **22,** l'écart du point **25** correspondant au compteur qui transite des charges significatives s'accroît avec la grandeur relative de la résistance de rattachement du compteur et aussi avec le nombre de compteurs qui participent au calcul de la série-tension du transformateur. Dans ce cas extrême, la similarité basée sur la distance peut donner un résultat erroné pour le compteur qui transite des charges significatives alors que la corrélation apparait préférable puisqu'il y a une bonne colinéarité entre tous les points pour un réseau basse tension avec les séries-tension correspondantes représentées dans l'espace multidimensionnel.

Dans la réalité, on peut fort bien observer différents extrêmes pour différents compteurs à différents moments. Une stratégie avantageuse consiste à appliquer la meilleure méthode au moment jugé opportun. Dans ce qui suit, nous dirons d'un compteur qu'il est silencieux s'il transite une faible charge ou dans le cas de la dérivée en tension, s'il transite une faible variation de charge. De même, nous dirons d'un compteur qu'il est bruyant s'il transite une forte charge ou dans le cas de la dérivée en tension, s'il transite une forte variation de charge en comparaison des autres compteurs rattaché au transformateur ciblé. Pour moduler la méthode entre les deux solutions extrêmes, soit celle pour un compteur silencieux et celle pour un compteur bruyant, une amélioration est apportée à la fonction de similarité basée sur la distance en corrigeant la tension mesurée au compteur pour prendre en compte la chute de tension associée à la charge qui traverse la résistance de raccordement du compteur, soit la résistance du câble reliant le compteur à la ligne. Avec cette correction, la similarité par la distance donne de bons résultats pour un compteur qui est entre l'état silencieux et l'état bruyant. Soit

$$v_{i,n}^{c} = v_{i,n} + R_i \cdot c_{i,n} \tag{19}$$

la série-tension corrigée au compteur $i$ avec

$$R_i = -\frac{\sum_{n=2}^{N} \left( \partial v_{i,n} - \partial v_{k,n} \right) \cdot \partial c_{i,n}}{\sum_{n=2}^{N} \left( \partial c_{i,n} \right)^2} \tag{20}$$

un facteur représentatif de la résistance de raccordement. Ce facteur a les unités d'Ohms lorsque la variable $c_{i,n}$ correspond au courant moyen calculé pour l'intervalle $n$. La grandeur $c_{i,n}$ peut aussi correspondre à la consommation en kWh ou à toute autre grandeur représentative de la charge au compteur. La Figure 6B illustre une représentation vectorielle de cette correction **27** dans l'espace multidimensionnel où $\partial \mathbf{C}_i = \{\partial c_{i,0}, \cdots, \partial c_{i,n}, \cdots, \partial c_{i,N}\}$. Dans l'expression 20, les dérivées discrètes

$$\partial v_{i,n} = v_{i,n} - v_{i,n-1} \ , \tag{21}$$

$$\partial v_{k,n} = v_{k,n} - v_{k,n-1} \ \text{ et} \tag{22}$$

$$\partial c_{i,n} = c_{i,n} - c_{i,n-1} \tag{23}$$

sont calculées pour $N$ enregistrements et donnent par conséquent $N$-1 valeurs de dérivée. Soulignons que pour les équations 20 à 23, les variables série-tension ne peuvent être substituées par des variables dérivés de série-tension contrairement aux autres expressions.

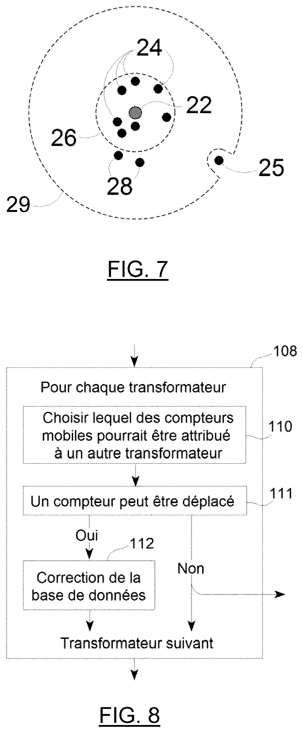

En référence à la Figure 7, il est illustré une représentation multidimensionnelle de tensions **24** de compteurs rattachés à un transformateur, avec au centre la série-tension **22** de ce transformateur et où un ensemble des compteurs dits immuables est circonscrit par une hypersphère représentée par le cercle intérieur **26** en pointillés, l'ensemble de tous les compteurs censés être rattachés au transformateur étant représenté par le cercle extérieur **29** en pointillés pouvant inclure ou non la représentation de la série-tension **25** d'un compteur en validation.

La série-tension au transformateur **22** apparaissant dans l'expression 22 (et 20 par extension) peut aussi être calculée de l'expression 2 sur différentes populations de compteurs, soit sur les compteurs immuables tel que

$$v_{k,n} = v_{k,n}^{U} \quad , \qquad\qquad (24)$$

soit sur la totalité des compteurs

$$v_{k,n} = \frac{1}{T_k} \cdot \sum_{j_k \in \mathbf{T}_k} v_{j,n} \qquad\qquad (25)$$

dans lequel cas est inclus ou non le compteur $i$ **25**. Pour le calcul du facteur R représentatif de la résistance de raccordement, une réalisation préférée de la méthode de calcul de $v_{k,n}$ est celle exprimée à l'équation 25 avec exclusion du compteur $i$.

La fonction de similarité distance s'écrit telle que

$$s_{i,k}^{Uc} = \sqrt{\sum_{n=1}^{N} \left( v_{i,n}^{c} - v_{k,n}^{U} \right)^2} \quad . \qquad\qquad (26a)$$

L'estimation de la résistance de raccordement donnée en 20 n'est pas limitée à la correction de la série-tension mesurée par un compteur : elle a plusieurs utilités, dont entre autres la détection de non-conformités électriques. En effet, à titre d'exemple, un circuit de contournement du compteur augmente la résistance apparente de raccordement. Il s'agit alors de fixer un seuil de résistance qui, au-delà du seuil, signifiera qu'il y a une forte probabilité de non-conformité électrique.

Selon une réalisation préférée de la méthode, soit l'équation 25 avec exclusion du compteur $i$, dans le cas où $c_{i,n}$ correspond à un courant, la résistance de raccordement estimée par l'équation 20 est plus grande ou égale à la valeur réelle de résistance de raccordement. Si le compteur est celui située le plus proche du transformateur alors l'espérance statistique $R_i$ pour un grand nombre de réalisations d'estimations équivaut à la résistance de raccordement. Si le compteur est raccordé le plus loin sur la ligne, considérant que plusieurs compteurs sont uniformément répartis sur la longueur de cette ligne, l'estimation donnée à l'équation 20 surestime la résistance d'environ d'une demi-longueur de la ligne sur lequel il est rattaché. Soulignons que le but souhaité de l'expression 20 n'est pas d'avoir une valeur non-biaisée de la résistance de raccordement mais bien de « rapprocher » la série-tension du compteur le plus possible de la série-tension du transformateur avant le calcul de distance.

Illustré dans l'espace multidimensionnel, la correction **27** proposée par l'expression 19 rapproche le point correspondant à la série-tension du compteur en validation **25** du point la série-tension au transformateur **22** et fait en sorte que la similarité par la distance donne de bons résultats même si le compteur est un peu « bruyant ». Par contre, cette correction peut amplifier ou introduire une erreur lorsque l'estimation de la résistance de raccordement est erronée. L'estimation de la résistance de raccordement d'un compteur est imprécise quand ce compteur ne transite pas de charge significative faisant en sorte que l'information sur la résistance de raccordement n'est pas présente dans les mesures pour ce compteur : cependant, comme il n'y a pas de manipulation significative de charge $c_{i,n}$ pour ce compteur, le résultat de l'expression 19 n'en n'est pas affecté. Le problème est différent en présence d'une non-conformité électrique ou d'une erreur de rattachement au bon transformateur qui altère l'estimation de la résistance de raccordement lorsque le compteur transite des charges significatives en regard des autres compteurs. Soulignons que si nous observons à l'occasion des valeurs de résistance de trop grande amplitude, nous observons aussi fréquemment des valeurs trop petites, voire même négatives. Deux seuils sont donc de préférence fixés, un seuil pour la valeur minimale acceptable de résistance de raccordement et un seuil pour la valeur maximale. Dans une réalisation préférée, le seuil minimal est fixé entre zéro et la résistance minimale attendu au secondaire d'un transformateur de distribution, soit entre zéro et typiquement moins de 10 mΩ. Le seuil maximal de résistance est fixé en correspondance avec la longueur de raccordement maximale anticipée et du gabarit du câble. Parmi les situations qui expliquent pourquoi la résistance de raccordement est située en dehors de ces seuils, il y a celle où le compteur n'est pas rattaché au transformateur ciblé, celle où la consommation transitée par le compteur est trop petite pour obtenir une estimation valable de la résistance de raccordement et celle où il y a une non-conformité électrique.

Dans la réalisation préférée, la valeur de résistance de raccordement est bornée par les seuils limites minimal et maximal fixés dans le calcul de la correction **27** (équation 19). Considérant que le calcul de la résistance de raccordement peut être erronée et/ou que les charges transitées ne correspondent pas à la réalité, le calcul de distance retient la valeur minimale de distance telle que

$$s_{i,k}^{Uc} = \min\left\{\sqrt{\sum_{n=1}^{N}\left(v_{i,n} - v_{k,n}^{U}\right)^2}, \sqrt{\sum_{n=1}^{N}\left(v_{i,n}^{c} - v_{k,n}^{U}\right)^2}\right\}, \qquad (26b)$$

soit la valeur minimale de distance sans ou avec correction de la perte de tension avec la charge.

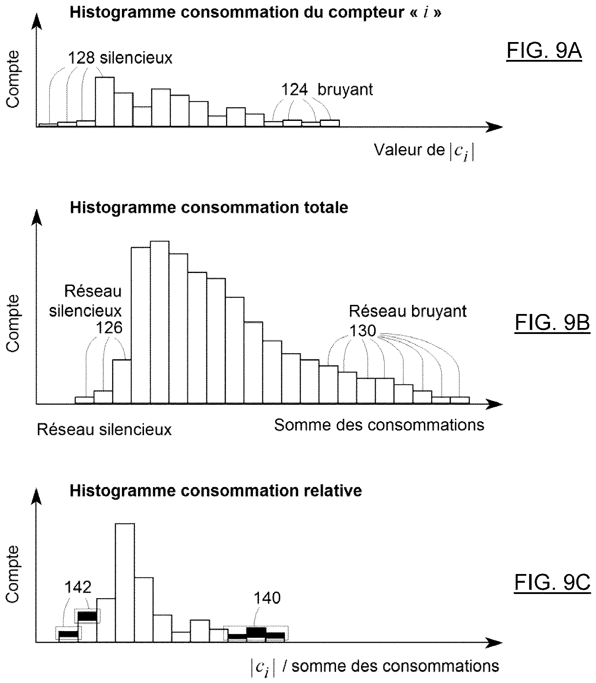

Si un compteur parle fort à l'occasion et que sa valeur de résistance de raccordement est située en dehors des seuils fixés alors que la tension de ce compteur est proche de la série-tension du transformateur ($v_{k,n}$ ou $v_{k,n}^{U}$) pour plusieurs enregistrements, c'est que ce compteur est fort probablement rattaché au transformateur et qu'il transite des charges ou une proportion de charge non avouée la plupart du temps : les correspondances de tensions sont observées aux moments où il n'y a pas de manipulation de charges. Si un compteur est toujours silencieux, il est normal que l'estimation de sa valeur de résistance de raccordement soit erronée mais, en contrepartie, la similitude par la distance est précise et doit le situer proche d'une série-tension d'un transformateur : il devrait être un compteur immuable. Dans une réalisation préférée, si un compteur mobile a sa valeur de résistance de raccordement située en dehors des seuils fixés pour le calcul effectué avec le transformateur auquel il se rattache finalement, ce compteur est qualifié de « non-conformité électrique potentielle » et son identifiant est ajouté à une liste des non-conformités électriques potentielles 117 (comme illustré aux Figures 5 et 9). Notons que s'il est déplacé plus d'une fois dans le processus, il se peut qu'il soit ajouté plus d'une fois sur la liste et qu'en finale, avec le dernier transformateur auquel il est assigné, il a sa valeur de résistance dans la plage valide : il est utile de conserver les déplacements successifs de tels compteurs pour un contrôle ultérieur.

À la fin du processus des attributions respectives de compteurs à des transformateurs, un classement et une analyse des indices de similarité permettent d'identifier des valeurs aberrantes (« outliers ») de similarité, s'il y en a. L'analyse peut par exemple consister à simplement utiliser une valeur seuil. Dans le cas de la corrélation un seuil minimal peut à cet effet être fixé à 20%. Si on n'arrive pas à relocaliser le compteur en validation ailleurs sur la ligne avec un meilleur pourcentage, cela peut indiquer par exemple qu'il n'est pas sur la ligne (on peut voir alors s'il ne devrait pas être attribué à un autre poste de transformation). Il y a bien évidemment aussi les corrélations de valeurs négatives qui seront considérées comme nulles et qui s'expliquent le plus souvent par des artefacts statistiques entre la série-tension d'un compteur et la série-tension d'un transformateur auquel il n'est pas raccordé. Dans le cas de la distance, la valeur seuil peut être fixée à 3 écarts types par rapport à la moyenne. Pour une valeur de similarité comprise entre 0 et 1, où 1 correspond au maximum de similarité, un remappage peut être effectué pour les valeurs proches de 1 pour tendre vers une distribution gaussienne. Les valeurs aberrantes peuvent être jointes à la liste de NCE potentielles 117. Notons qu'il se peut qu'un compteur non-communicant soit situé proche du compteur en validation, ou que le compteur soit rattaché à une autre ligne ou à un transformateur absent de la base initiale de données topologiques expliquant ainsi les valeurs aberrantes obtenues.

Nous disposons ainsi de deux moyens de qualifications de l'appariement d'un compteur à un transformateur, le premier, la corrélation, est sans unité et le second, la distance, est exprimé en volts. Le premier moyen peut avantageusement être maximisé alors que le second peut avantageusement être minimisé. Il s'agit de combiner adéquatement ces deux expressions afin de transiter de l'une à l'autre avec une certaine continuité. Nous proposons un remappage de la distance pour qu'elle soit dans le même domaine que la corrélation, soit [0.0,1.0] et où le maximum de similarité a pour valeur l'unité. Dans ce remappage on souhaite conserver la sensibilité qu'a la distance avec la différence de longueur des vecteurs comparés, ce que la corrélation n'a pas puisqu'elle est un indice de colinéarité entre les vecteurs sans égard à leurs différences de longueur. Rappelons le lien entre ces deux expressions : soit $\mathbf{V}_a$ et $\mathbf{V}_b$ deux vecteurs correspondant chacun, dans notre contexte, à une série de tensions mesurées. Le carré de la distance multidimensionnelle

$$\left\|\mathbf{V}_a - \mathbf{V}_b\right\|^2 = \left\|\mathbf{V}_a\right\|^2 + \left\|\mathbf{V}_b\right\|^2 - 2\cdot\left(\mathbf{V}_a \cdot \mathbf{V}_b\right) \text{ , où } \left\|...\right\| \text{ est l'opérateur norme,} \qquad (27)$$

est fonction de la corrélation puisque

$$\mathbf{V}_a \cdot \mathbf{V}_b = \left\|\mathbf{V}_a\right\| \cdot \left\|\mathbf{V}_b\right\| \cdot \cos(\theta) \text{ ,} \qquad (28)$$

avec l'angle $\theta$ étant l'angle entre les deux vecteurs dans l'espace multidimensionnel, et que le cosinus de cet angle est le coefficient de corrélation tel que $\gamma = \cos(\theta)$. Puisque $d_{a,b} = \left\|\mathbf{V}_a - \mathbf{V}_b\right\|$, ceci donne la relation

$$\gamma_{a,b} = \frac{\|\mathbf{V}_a\|^2 + \|\mathbf{V}_b\|^2 - d_{a,b}^2}{2 \cdot \|\mathbf{V}_a\| \cdot \|\mathbf{V}_b\|} = \frac{\|\mathbf{V}_a\|^2 + \|\mathbf{V}_b\|^2}{2 \cdot \|\mathbf{V}_a\| \cdot \|\mathbf{V}_b\|} - \frac{d_{a,b}^2}{2 \cdot \|\mathbf{V}_a\| \cdot \|\mathbf{V}_b\|} \ . \tag{29}$$

Dans cette expression de la corrélation, le terme de gauche compense pour la distance qui provient de la différence entre les grandeurs des vecteurs. En effet, on a

$$\frac{\|\mathbf{V}_a\|^2 + \|\mathbf{V}_b\|^2}{2 \cdot \|\mathbf{V}_a\| \cdot \|\mathbf{V}_b\|} \geq 1$$

avec l'égalité à l'unité lorsque les vecteurs sont de même grandeur. Si nous remplaçons ce terme de gauche par l'unité, il n'y a plus de compensation telle que désirée pour le remappage de la distance vers la corrélation. Soit alors

$$\gamma_{a,b}^d \equiv 1 - \frac{d_{a,b}^2}{2 \cdot \|\mathbf{V}_a\| \cdot \|\mathbf{V}_b\|} \tag{30}$$

la fonction de remappage de la distance vers la corrélation.

Avec l'augmentation de l'amplitude de manipulation de charge, on passe de la situation illustrée à la Figure 7 vers celle illustrée aux Figures 6A et 6B. La correction de la série-tension au compteur proposée en 19 et insérée dans le calcul de la distance $s_{i,k}^{Uc}$ permet d'harmoniser le passage de la distance à la corrélation, la distance étant calculée lorsque le compteur n'est pas bruyant et la corrélation étant calculée lorsque le compteur est plus bruyant. Définissons

$$\gamma_{i,k}^{Ud} \equiv 1 - \frac{\left(s_{i,k}^{Uc}\right)^2}{2 \cdot \|\mathbf{V}_i\| \cdot \|\mathbf{V}_k\|} \quad \text{avec } s_{i,k}^{Uc} = \min\left\{ \sqrt{\sum_{n=1}^{N}\left(v_{i,n} - v_{k,n}^U\right)^2}, \sqrt{\sum_{n=1}^{N}\left(v_{i,n}^c - v_{k,n}^U\right)^2} \right\} \tag{31 a}$$

$$\|\mathbf{V}_i\| = \sqrt{\sum_{n=1}^{N} v_{i,n}^2} \quad \text{et} \quad \|\mathbf{V}_k\| = \sqrt{\sum_{n=1}^{N}\left(v_{k,n}^U\right)^2} \tag{31 b}$$

comme l'équivalent d'un coefficient de corrélation calculée à partir de la distance entre la série-tension d'un compteur et celle d'un transformateur.

Les deux indicateurs peuvent être fusionnés comme suit. En référence aux Figures 9A, 9B et 9C, basé sur l'hypothèse que les différents compteurs ne manipulent pas en synchronisme leurs charges, il existe pour un compteur des moments où il est silencieux alors que les autres sont bruyants et inversement, des moments où il est bruyant alors que les autres sont silencieux. Les exceptions à cette hypothèse se trouvent, entre autres, dans les services de téléphonie et de câblodistribution où les compteurs sont essentiellement silencieux puisqu'ils transitent de faibles charges. Hormis ces exceptions, les histogrammes illustrant la consommation pour un compteur (en termes de consommation, de courant ou des dérivées discrète de ces derniers) tout comme la probabilité de la somme des consommations pour un transformateur démontrent qu'il y a des opportunités où l'un ou l'autre, le compteur ou le réseau, est silencieux alors que l'autre est bruyant.

Par exemple, un compteur peut se montrer bruyant **124** ou silencieux **128**. De même, la somme des consommations des compteurs peut être bruyante **130** ou silencieuse **126**. Parmi les occasions qu'un compteur se montre bruyant **124**, il peut à certaines de ces occasions **140** l'être alors que la somme de l'ensemble des compteurs apparaît silencieuse **126**, soit pour une proportion élevée de consommation entre celle du compteur et de la somme des compteurs. Inversement, parmi les occasions qu'un compteur se montre silencieux **128**, il peut à certaines de ces occasions **142** l'être alors que la somme de l'ensemble des compteurs apparaît bruyante **130**, soit pour un rapport petit de consommation entre celle du compteur et de la somme des compteurs. Il s'agit de profiter de ces opportunités statistiques pour appliquer la similarité par corrélation dans le premier cas et la similarité par distance dans le second. On comprend que ces opportunités décroissent rapidement avec l'intervalle d'interrogation des compteurs (15 minutes, 60 minutes, 1 heure).

Soit

$$s_{i,k}^{g} = \mathrm{S}^{g}\left(s_{i,k}^{Uc}, \gamma_{i,k}^{U}, c_{i,n}, c_{k,n}\right) \text{ avec } c_{k,n} = \sum_{j \in \mathbf{T}_k} c_{j,n} \tag{32}$$

la fonction de similarité généralisée entre la série-tension du compteur $i$ et un transformateur $k$ qui est fonction 1) de la distance entre deux séries-tension exprimées dans un espace multidimensionnel, 2) de la corrélation entre ces séries et 3) des séries temporelles de consommation du compteur $c_{i,n}$, et des séries temporelles $c_{k,n}$ de consommation des compteurs rattachés au transformateur $k$. La plus grande valeur de similarité détermine à quel transformateur est rattaché le compteur. Notons que dans cette réalisation préférée, les corrélations et les distances sont effectuées entre le compteur en validation et la série-tension du transformateur calculée à partir des séries-tensions des compteurs immuables.

Dans une réalisation, la fonction de similarité généralisée

$$s_{i,k,\mathbf{M}}^{g} = \left(\left(1 - P_{i,\mathbf{M}}\right) \cdot \gamma_{i,k}^{Ud}\right)^{e} + \left(P_{i,\mathbf{M}} \cdot \gamma_{i,k}^{U}\right)^{e}, \tag{33}$$

avec la fonction de répartition (ou d'aiguillage)

$$P_{i,\mathbf{M}} = G\left(\frac{\sum_{n \in \mathbf{M}} \delta c_{i,n}^{2}}{\sum_{i} \sum_{n \in \mathbf{M}} \left(\delta c_{i,n}\right)^{2}}\right), \quad 0 \le P_{i,\mathbf{M}} \le 1.0, \tag{34}$$

est calculée pour M enregistrements temporels non nécessairement contigus tel que $n \in \mathbf{M}$, soit que l'indice temporel $n$ d'un enregistrement est élément de l'ensemble $\mathbf{M}$ des indices considérés pour ce calcul. L'exposant «c» est préférablement fixé proche de l'unité. La fonction de répartition peut, par exemple, être une racine carrée, une racine $T_k$ ième ou une fonction polynômiale écrêtée entre zéro et l'unité.

Cette formulation (éq. 34) a le désavantage de mélanger les circonstances où le compteur à valider est silencieux avec d'autres moments où il est bruyant. Idéalement, il est préférable de séparer ces moments et les cumuler chacun avec la fonction de similarité appropriée. Dans une réalisation préférée, la fonction de similarité généralisée

$$s_{i,k}^{g} = \frac{N^{S} \cdot \gamma_{i,k}^{Ud} + N^{B} \cdot \gamma_{i,k}^{U}}{N^{S} + N^{B}} \tag{35}$$

où, de l'équation 17,

$$\gamma_{i,k}^{U} = \frac{\sum_{n \in \mathbf{N}^{S}} \left(v_{i,n} - \overline{v}_i\right) \cdot \left(v_{k,n}^{U} - \overline{v}_k^{U}\right)}{\sqrt{\sum_{n \in \mathbf{N}^{S}} \left(v_{i,n} - \overline{v}_i\right)^{2} \cdot \sum_{n \in \mathbf{N}^{S}} \left(v_{k,n}^{U} - \overline{v}_k^{U}\right)^{2}}} \tag{36}$$

et

$$\gamma_{i,k}^{Ud} = 1 - \frac{\sum_{n \in \mathbf{N}^{B}} \left(v_{i,n} + R_i \cdot c_{i,n} - v_{k,n}^{U}\right)^{2}}{2 \cdot \sqrt{\sum_{n \in \mathbf{N}^{B}} \left(v_{i,n} + R_i \cdot c_{i,n}\right)^{2} \cdot \sum_{n \in \mathbf{N}^{B}} \left(v_{k,n}^{U}\right)^{2}}} \tag{37}$$

avec $N^{S}$ l'ensemble des enregistrements où le compteur est silencieux et $N^{B}$ l'ensemble des enregistrements où le compteur est bruyant, et ce, tel que

$$N^S = \sum_{n \in \mathbf{N}^S} 1$$

et

$$N^B = \sum_{n \in \mathbf{N}^B} 1 \quad .$$

La fonction de répartition

$$P_{i,n} = \frac{\left|\delta c_{i,n}\right|}{\sqrt{\sum_j \left(\delta c_{j,n}\right)^2}} , \tag{38}$$

caractéristique de la consommation relative entre la consommation du compteur et celle des tous les compteurs, permet de partager les enregistrements entre les bruyants et les silencieux tel que

$$i \in \mathbf{N}^S \ \text{si} \ P_{i,n} < Seuil\_silencieux \tag{39a}$$

et

$$i \in \mathbf{N}^B \ \text{si} \ P_{i,n} \geq Seuil\_bruyant \tag{39b}$$

avec bien sûr *Seuil_bruyant≥Seuil_silencieux.* Les seuils peuvent être fixés avant l'exécution de la méthode, peuvent être fonction du nombre de compteurs ou ajustés dynamiquement, voire itérativement afin d'obtenir une répartition judicieuse. Dans une réalisation préférée, la valeur initiale est la même pour les deux seuils et est de 20%. La fonction de similarité généralisée a sa valeur comprise entre zéro et l'unité. Cette fonction a une valeur maximale lorsque le compteur est attribué au bon transformateur.

Le cas des éclairages de ville est un exemple pour lequel la fonction de similarité généralisée donnée à l'équation 35 donne de bien meilleurs résultats que celle donnée à l'équation 33. En effet, un éclairage de ville a toujours approximativement la même consommation et commute deux fois par jour. Qu'il soit allumé ou éteint, l'éclairage de ville est parfaitement silencieux en ce qui concerne la dérivée de la série-tension. Ce n'est que lorsqu'il commute qu'il est bruyant. Combiner la similitude par la distance pour les périodes où il est silencieux et la similitude par la corrélation lorsqu'il commute donne le meilleur résultat.

En référence à nouveau à la Figure 5, de façon optimale, on choisit de préférence un seul compteur parmi tous les transformateurs qui pourrait être attribué à un autre transformateur **108** et si un compteur est déplacé, on corrige la base de données et on retourne à l'étape du calcul de similarité **104** où l'on recalcule les similarités pour les deux transformateurs touchés par le déplacement du compteur.

En référence à la Figure 8, une autre façon moins onéreuse en temps de calcul de réaliser l'étape **108** peut être de, pour chaque transformateur, choisir lequel des compteurs mobiles pourrait être attribué à un autre transformateur comme illustré au bloc **110,** corriger la base de donnée comme illustré au bloc **112** si le compteur est déplacé comme illustré au bloc **111** et passer au transformateur suivant jusqu'à ce que tous les transformateurs soient traités. Si au moins un compteur est déplacé, on retourne à l'étape du calcul de similarité où l'on recalcule, au minimum, les termes pour les transformateurs touchés par les réattributions. Quelle que soit la façon **108** utilisée, le traitement se termine quand aucun compteur n'est déplacé comme vérifié à l'étape **113** (illustrée à la Figure 5).

À l'étape **108,** un compteur peut être déplacé si sa similarité augmente avec le déplacement. Lorsque plus d'un compteur peut être déplacé, un choix est de préférence réalisé sur le compteur le plus pertinent à déplacer, ce qui est réalisé à l'étape **110.** Pour chaque compteur qui peut être déplacé, nous disposons de la grandeur de similarité qu'il a avec le transformateur $k$ auquel il est raccordé et la grandeur de similarité qu'il a avec le transformateur $l$ ciblé par ce déplacement. Soit alors

$$\mathrm{f}\left(s_{i,k}^g, s_{i,l}^g\right) \tag{40}$$

la fonction combinée des similarités à optimiser (minimiser ou maximiser selon le cas) dans le choix du compteur à déplacer où $k$ et $l$ sont respectivement l'indice du transformateur de départ et l'indice du transformateur ciblé par le déplacement. Ici, une personne de l'art pourra imaginer plusieurs fonctions possibles. Une réalisation préférée de la méthode s'écrit

$$\mathrm{f}\left(s_{i,k}^g, s_{i,l}^g\right) \equiv s_{i,l}^g - s_{i,k}^g \tag{41}$$

de telle sorte que parmi les compteurs mobiles, ce sera celui qui donne un maximum à la fonction combinée de similarité qui sera sélectionné comme compteur à déplacer.

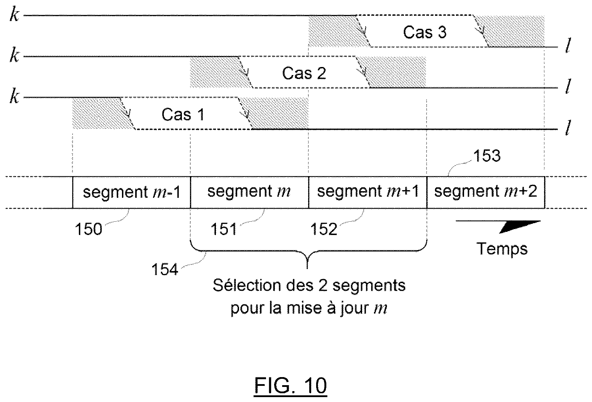

En référence à la Figure 10, le cas d'une sélection temporelle de données **154** où se produit un déplacement de compteur peut être traité spécifiquement pour déterminer le moment de déplacement du compteur. L'impact d'un tel déplacement est une valeur de similitude située entre les valeurs obtenues pour chaque transformateur si le compteur avait été rattaché à l'un ou à l'autre de ces transformateurs. Dans $R^N$, c'est comme si l'on traçait une ligne entre la position de départ de la série-tension avant déplacement du compteur et la position d'arrivée après déplacement. Le point correspondant à la sélection temporelle se déplace alors proche de cette ligne du départ à l'arrivée selon la proportion des enregistrements de tension contribuant au calcul et provenant d'avant et après le déplacement du compteur. Selon une méthode dite différentielle comme illustrée à la figure 10, dans une première étape la sélection **154** comprend au moins deux segments temporels successifs **151** et **152** suivi d'un calcul d'attribution compteur à transformateur **110** (comme illustré à la Figure 9) effectué pour chaque segment, par exemple, en retenant le transformateur, $k$ ou $l$, qui maximise l'équation 35. Les sélections peuvent être successives et juxtaposées d'une mise à jour à l'autre, par exemple la sélection $m$ comprend les segments $m$ **151** et $m+1$ **152** et la sélection $m+1$ comprend les segments $m+1$ **152** et $m+2$ **153.** Pour une mise à jour $m,$ il existe trois possibilités pour deux segments calculés, soit :

- dans un premier cas, le déplacement du compteur survient entre le début du second segment de la mise à jour précédente (segment $m$-1) **150** et la fin du premier segment de la mise à jour courante (segment $m$) **151,** alors le segment $m$ **151** et le segment $m+1$ **152** indiquent respectivement possiblement et certainement un déplacement du compteur de $k$ vers $l$, soit $s_{i,l} > s_{i,k}$ est nécessairement validé pour le segment $m+1$,,
- dans un second cas, le déplacement du compteur survient entre le début du premier segment de la mise à jour courante (segment $m$) **151** et la fin du second segment de la mise à jour courante (segment $m+1$) **152,** alors le segment $m$ **151** et le segment $m+1$ **152** indiquent tous les deux possiblement un déplacement du compteur,
- dans un troisième cas, le déplacement du compteur survient entre le début du second segment de la mise à jour courante (segment $m+1$) **152** et la fin du premier segment de la mise à jour suivante (segment $m+2$) **153,** alors le segment $m$ **151** et le segment $m+1$ **152** indiquent respectivement aucun déplacement de compteur et possiblement un déplacement du compteur.

On notera la superposition de ces possibilités. En réalité, les superpositions sont minimes et situées aux milieux des segments comme illustré par les parallélépipèdes à la Figure 10. Les deux premiers cas peuvent être traités lors de la mise à jour courante $m$ alors que le troisième cas sera traité par la mise à jour suivante m+1 : on comprend que la méthode « échappera » un déplacement de compteur qui surviendra vers la fin du dernier segment et que la plus récente topologie trouvée sera celle avoisinant le milieu du second segment. Une méthode alternative est de considérer l'écart de similarité entre deux segments successifs (...,$m$-1 et $m$, $m$ et $m+1$,...) effectué par rapport au transformateur auquel il est rattaché en regard d'un seuil déclencheur afin de détecter une baisse de similarité que l'on attribuera à un déplacement probable du compteur. Cet exemple peut être repris en y ajoutant des segments additionnels.

La méthode différentielle détecte un déplacement de compteur et le localise grossièrement, soit à une longueur de segment près. Lorsqu'un déplacement du compteur d'indice $i$ est détecté entre le transformateurs $k$ vers le transformateur $l$, pour accroître la résolution de la localisation temporelle du déplacement, il s'agit de refaire le calcul de similarité pour les parties distinctes, soit avant ($n < x$) et après ($n \geq x$) le déplacement du compteur, tel que

$$s_{i,k,l,x} = s_{i,\left(k_{n<x}, l_{n \geq x}\right)}^g \tag{42}$$

où x est un nombre entier positif tel que $x \in \{0,1,2,3...,N\}$ déterminant la plage de calcul pour l'indice temporel $n$. Ce calcul de similarité sera réalisé pour différentes positions temporelles $x$ de déplacement afin de déterminer la position qui donne la meilleure similarité. Typiquement, on choisira un intervalle d'enregistrements temporels d'exploration de la plage 0-*N* correspondant à une journée pour la grandeur des pas de positions.

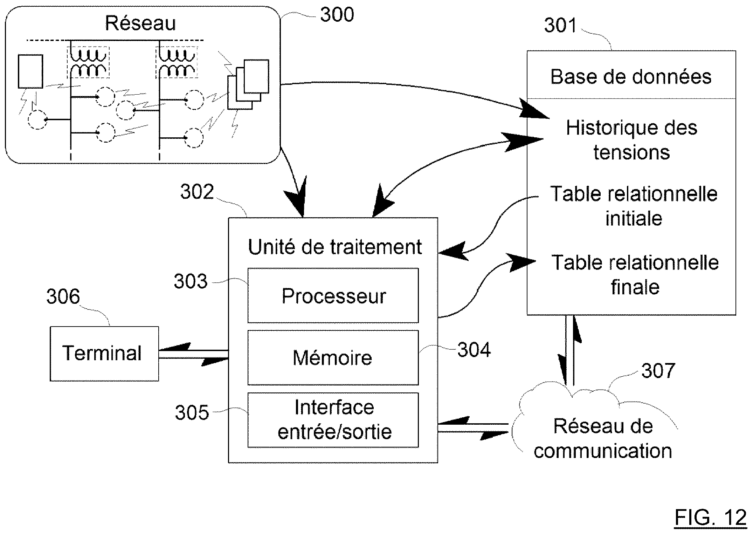

Une fois que le schéma de déplacement d'un compteur entre deux transformateurs est trouvé, les informations {*i,k,l,x*} obtenus de l'optimisation de 42 font de préférence partie de la correction réalisée à l'étape **108** et sont rangées dans la base de données **301** (comme illustrée à la Figure 12).

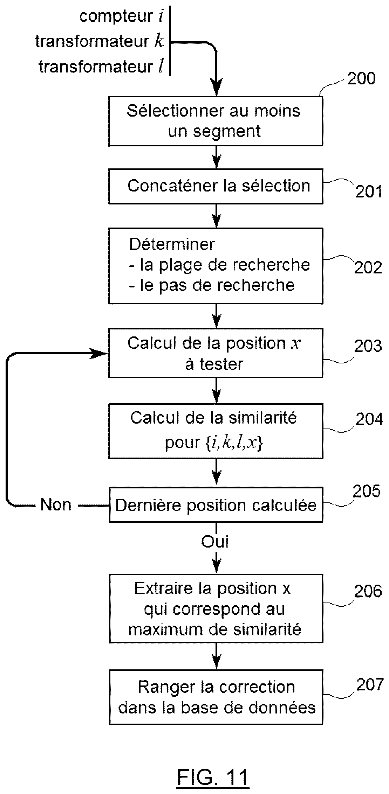

La Figure 11 illustre des étapes d'une méthode d'estimation de la position temporelle correspondant au moment du déplacement d'un compteur. Au départ, l'indice *i* du compteur déplacé ainsi que les indices {*k,l*} des transformateurs de départ et d'arrivée sont connus et proviennent possiblement de la méthode qui se réfère à la Figure 10. Soit alors la série d'étapes :

1. sélectionner au moins un segment **200,**
2. concaténer les segments sélectionnés pour former un seul segment continu **201,**
3. déterminer la plage de recherche où seront testées les positions x et le pas de recherche **202,**
4. calculer la position x à tester **203,**
5. calculer la similarité pour cette position **204,**
6. si la dernière position à tester est traitée, passez à l'étape 7 sinon retourner à l'étape 4 **205,**
7. extraire la position x qui correspond au maximum de similarité **206,**
8. ranger dans la base de données **301** la correction déterminée à partir du résultat de l'étape 7 pour ce déplacement **207.**

Cette méthode peut être avantageusement modifiée pour réduire l'effort de calcul en modifiant les étapes 3 à 7 pour qu'elles correspondent à une recherche dichotomique où à chaque étape la plage de recherche est réduite de moitié. D'autres méthodes d'application de l'équation 42 peuvent être utilisées afin d'estimer la position x correspondant au moment du déplacement du compteur.

Une réalisation préférée en ce qui regarde les différentes étapes, et plus particulièrement les équations 2 et 15 pour le calcul de la série-tension d'un transformateur et le calcul de la série-tension corrigée d'un transformateur, tiendra compte de la position x dans l'attribution du membre *i* à l'ensemble $\mathbf{T}_k$ dans la formulation $i \in \mathbf{T}_k$ afin de tenir compte du déplacement de chaque compteur dans le temps pour attribuer la portion de la série-tension (ou dérivée de la série-tension) mesurée par un compteur au transformateur raccordé pour cette portion temporelle.

Au départ de l'application de la méthode, la description topologique peut correspondre à un portrait de celle-ci à un instant donné ou encore une description topologique où les informations {*k,l,x*} sont connues historiquement pour chaque compteur. Cependant, le résultat donné par l'application de la méthode est de préférence organisé pour être dynamique dans le temps, de façon à comprendre un historique des déplacements de compteurs et de cet historique pouvoir en extraire une topologie correspondante pour un moment désiré. Une situation de l'état de la topologie, les données exploitées et la progression de l'exécution de la méthode selon l'invention à tout moment choisi par l'utilisateur ou en continu peuvent être présentées sur une interface utilisateur en temps réel ou non sous forme graphique, de données, d'images, de graphes, de schémas, de messages, etc.

La méthode selon l'invention permet de mettre à jour une topologie présentant une proportion moyenne minimale *α* de bonnes attributions. Dans le cas où cette proportion minimale n'est pas atteinte et qu'il n'y a pas de convergence vers une solution plausible ou dans le cas où il n'y a pas d'information sur la topologie du réseau dans la base de données, il est proposé une méthode qui construit imparfaitement une première topologie qui pourra par la suite être corrigée par la méthode de correction selon l'invention. Soit des nuages constitués des séries-tensions des compteurs **24** tels qu'illustrés à la Figure 3 et où les compteurs ne sont pas attribués à un transformateur. Il s'agit de « clusteriser » ces points dans R$^N$ afin de regrouper pour chaque nuage les points correspondant à un transformateur. Un exemple de moyen de clustering non optimal mais plus efficace en temps de calcul qu'un algorithme *k-means* usuel est proposé dans US2014/0100821 (Léonard) intitulé « Dynamic clustering of transient signals ». S'il est connu, le nombre de transformateurs sur le réseau fixe le nombre maximal de « clusters » à traiter par cette méthode. L'application de cette méthode de « clustering » ou toute autre méthode similaire produira des clusters distincts correspondant chacun à un transformateur. Par contre, le lien cluster à transformateur reste à faire. En l'absence d'information dans la base de données qui permettrait de rattacher au moins un compteur à un transformateur pour chaque cluster construit par la méthode, il faut alors se déplacer sur le terrain dans le réseau pour lier chaque cluster à un identifiant (ID) transformateur. Une fois les liens cluster à transformateur réalisés, il faut soumettre cette estimation de topologie à la méthode décrite plus haut afin de mettre à jour précisément la topologie. En ce qui concerne un compteur rattaché à un seul transformateur selon la topologie initiale, celui-ci est de facto immuable. De même, si l'on retire un compteur d'un transformateur de sorte qu'il reste un seul compteur, le dernier compteur qui reste est immuable. En ce qui concerne le cas de deux compteurs rattachés à un transformateur, ce cas est traité de telle sorte que le transformateur est dédoublé pour les validations, soit une validation avec un compteur qui est immuable et la seconde validation avec l'autre compteur qui est immuable.

Le tableau A présente les résultats obtenus pour une ligne comportant 116 transformateurs avec 1118 lieux de consommation. Une validation exhaustive sur le terrain a permis de confirmer 24 erreurs d'association dans la base de données topologiques non corrigée. Pour une résolution de 0.01V et 0.01kWh avec une lecture aux 15 minutes, la méthode proposée a détecté 23 des 24 erreurs d'association avec seulement deux faux positifs, ce qui correspond respectivement à un taux d'exactitude de 92 % et un rappel de 96 %, en regard des 24 erreurs d'association. On remarquera que l'exactitude de la méthode diminue avec l'allongement de la durée de l'intervalle de lecture et peut ne pas être fiable pour une résolution de 1V et 1kWh

| Tableau A | | | | | | |
| Résultats obtenu pour une ligne moyenne tension comportant 1118 lieux de consommation en fonction de la résolution de la mesure et de l'intervalle temporel de lecture | | | | | | |
|---|---|---|---|---|---|---|
| Résolution mesure | 0.01V et 0.01kWh | | | 1V et 1kWh | | |
| Intervalle temporel | 15 min | 30 min | 60min | 15 min | 30 min | 60 min |
| Faux positif | 2 (8%) | 2 (8%) | 3 (13%) | 32 (68%) | 94 (87%) | 211 (98%) |
| Faux négatif | 1 (4%) | 3 (13%) | 4 (17%) | 9 (38%) | 10 (42%) | 19 (79%) |

En référence à la Figure 12, il est illustré un exemple de système informatique et un arrangement physique de connectivité avec différents appareils exploités par la méthode selon l'invention. Une unité de traitement **302,** comprenant au moins un processeur **303** et une mémoire **304,** et dotée d'une interface entrée/sortie **305,** reçoit les données ou enregistrements de tension des compteurs du réseau **300** ou d'une base de données **301** pouvant contenir les historiques de mesures de tensions et des tables relationnelles ou autre structure de stockage de données qui décrivent la topologie du réseau. La base de données contenant les mesures de tension des compteurs peut être distribuée à travers les compteurs s'ils sont dotés de dispositifs ou fonctionnalités de stockage pouvant être interrogés au besoin ou encore à travers des dispositifs de stockage des mesures de compteurs sur un réseau de distribution comme tel ou encore sur un dispositif de stockage de données central recevant les données fournies par les compteurs, ou encore un mélange de tout ce qui précède.

L'unité de traitement a en sa mémoire **304** des instructions exécutables par le processeur **303** et configurant l'unité de traitement **302** pour effectuer les étapes de la méthode selon l'invention, comme décrit ci-dessus. Le réseau **300** comprend le réseau électrique de distribution et de consommation, les compteurs intelligents et tout équipement de communication, serveurs et base de données rattachés à ce réseau. L'historique des tensions contenu dans la base de données **301** peut avoir été généré et déposé dans celle-ci par le réseau **300** et/ou par l'unité de traitement **302.** L'unité de traitement **302** peut être configurée par un terminal **306** rattaché à celle-ci ou par un autre équipement rattaché à celle-ci par un réseau de communication **307.** Selon une réalisation, la configuration comprend entre autres l'intervalle entre deux exécutions automatiques de la mise à jour de la topologie et le choix du paramètre $\alpha$. Lorsque disponible dans la base de données **301,** la table relationnelle décrivant la topologie du réseau de distribution est transmise à l'unité de traitement **302,** sinon l'unité de traitement applique une méthode de « clustering » pour trouver une première estimation de topologie. L'unité de traitement **302** peut débuter l'application de la méthode par la sélection des segments **101** (comme illustré à la Figure 5) en interrogeant la base de données **301** pour obtenir l'historique des tensions et termine le traitement en transmettant à la base de données **301** la table relationnelle de la topologie mise à jour. La mise à jour des données peut aussi se faire au fur et à mesure de la progression de la méthode. La base de données **301,** et plus particulièrement les tables relationnelles contenues dans celle-ci, peuvent être consultées par d'autres applications par exemple à partir du réseau de communication **307.**

**Revendications**

1.   Méthode par système informatique de correction automatique d'une topologie d'un réseau de distribution électrique définie par des attributions respectives de compteurs à des transformateurs, la méthode comprenant les étapes de:

   (i) pour chaque transformateur de la topologie, partager (105) les compteurs attribués au transformateur en des premier et deuxième lots selon un critère de partage et un degré de similarité (104) des enregistrements de tensions mesurées par les compteurs par rapport à une tension moyenne évaluée avec les enregistrements de tensions mesurées par les compteurs attribués au transformateur de manière que le premier lot comprenne les compteurs dont le degré de similarité est plus élevé que les compteurs du deuxième lot; et **caractérisée en ce que**:

(ii) initialement pour chaque transformateur de la topologie puis subséquemment pour chaque transformateur dont l'attribution de compteurs a changé, calculer (106) une tension moyenne corrigée avec les enregistrements de tensions mesurées par les compteurs uniquement dans le premier lot du transformateur;
(iii) calculer (107) une similarité des enregistrements de tensions mesurées des compteurs dans les deuxièmes lots des transformateurs avec les tensions moyennes corrigées des transformateurs calculées en (ii);
(iv) pour chaque transformateur de la topologie, déterminer (108) quels sont, dans le deuxième lot, les compteurs attribuables à un autre transformateur selon les similarités calculées en (iii);
(v) réattribuer (113) au moins un des compteurs déterminés en (iv); et
(vi) tant qu'un compteur a été réattribué en (v), répéter les étapes (ii) à (v),

la topologie étant corrigée lorsqu'il ne reste plus de compteurs attribuables à d'autres transformateurs dans les deuxièmes lots.

2. La méthode selon la revendication 1, comprenant de plus l'étape entre les étapes (iv) et (v) de prioriser au moins un compteur à réattribuer selon un ordre décroissant des similarités calculées en (iii).

3. La méthode selon la revendication 1, dans laquelle la similarité calculée en (iii) est déterminée en fonction:

d'une analyse multidimensionnelle des enregistrements de tensions mesurées, la similarité étant quantifiée selon des distances entre des tensions de séries temporelles des enregistrements par rapport aux tensions moyennes des transformateurs représentées dans un espace multidimensionnel;
d'une analyse de corrélations entre les séries temporelles des enregistrements;
ou de résultats d'une fonction combinant les résultats des analyses multidimensionnelle et de corrélation.

4. La méthode selon la revendication 3, dans laquelle la similarité calculée en (iii) est déterminée de plus en fonction d'une contribution de séries temporelles d'enregistrements de consommations mesurées par les compteurs.

5. La méthode selon la revendication 3, dans laquelle un aiguillage des enregistrements de tensions entre l'analyse multidimensionnelle et l'analyse de corrélations est effectué en fonction de niveaux de consommation déterminés à partir de séries temporelles correspondantes d'enregistrements de consommations mesurées par les compteurs.

6. La méthode selon la revendication 3, dans laquelle la fonction combinant les résultats comprend une projection d'une distance vers une corrélation selon l'équation:

$$\gamma_{a,b}^{d} \equiv 1 - \frac{d_{a,b}^{2}}{2 \cdot \left\| \mathbf{V}_a \right\| \cdot \left\| \mathbf{V}_b \right\|}$$

où $V_a$ et $V_b$ sont des vecteurs correspondant à des séries d'enregistrements de tensions mesurées par un compteur en validation dans l'espace multidimensionnel, $d_{a,b}$ est une distance entre des extrémités des vecteurs dans l'espace multidimensionnel, et $\left\| ... \right\|$ est un opérateur norme.

7. La méthode selon la revendication 3, dans laquelle la similarité calculée en (iii) pour un compteur en validation comprend de plus:

une estimation d'une résistance de raccordement du compteur en validation à partir des enregistrements de tensions mesurées par le compteur en validation, une tension moyenne évaluée avec les enregistrements de tensions de tous les compteurs rattachés au transformateur visé par le calcul de similarité, et des grandeurs représentatives d'une charge au compteur en validation selon des enregistrements de consommations mesurées par le compteur en validation; et
une correction de la tension mesurée par le compteur en validation en fonction de la résistance de raccordement estimée et des enregistrements de consommations mesurées par le compteur en validation.

8. La méthode selon la revendication 7, dans laquelle la résistance de raccordement du compteur en validation est évaluée en fonction de variations d'amplitudes entre les enregistrements.

9. La méthode selon la revendication 7, dans laquelle une non-conformité électrique potentielle est détectée selon que la résistance de raccordement du compteur en validation a une valeur hors d'une plage valide prédéfinie.

10. La méthode selon la revendication 1, comprenant de plus, avant l'étape (i), l'étape de sélectionner des segments de données définissant des plages temporelles des enregistrements auxquels les calculs dans les étapes (i) à (iii) sont appliqués.

11. La méthode selon la revendication 10, comprenant de plus l'étape de valider les données dans les segments en détectant des pannes et anomalies dans les données et en rejetant les enregistrements temporels correspondants.

12. La méthode selon la revendication 1, comprenant de plus les étapes de:

communiquer avec une base de données topologiques d'un réseau électrique pour obtenir des données indicatives de la topologie du réseau de distribution électrique et mettre à jour les données en fonction de réattributions des compteurs en (v); et
communiquer avec une base de données emmagasinant des mesures fournies par les compteurs pour obtenir les enregistrements de tensions mesurées par les compteurs.

13. La méthode selon la revendication 12, dans laquelle les données mises à jour comprennent un historique des réattributions des compteurs aux transformateurs de manière à suivre une évolution de la topologie et qu'une configuration de la topologie à un moment donné soit déterminable.

14. La méthode selon la revendication 12, dans laquelle la similarité calculée en (iii) comprend de plus:

une détection d'une réattribution d'un compteur d'indice $i$ d'un transformateur $k$ vers un transformateur $l$; et
une optimisation d'une localisation temporelle de la réattribution en calculant une similarité pour différentes positions temporelles x de réattribution avant et après la réattribution du compteur tel que

$$s_{i,k,l,x} = s^{g}_{i,(k_{n<x}, l_{n \geq x})}$$

où x est un nombre entier positif tel que $x \in \{0,1,2,3..., N\}$ déterminant une plage de calcul pour l'indice temporel $n$, la position qui donne la similarité la plus grande étant retenue, les informations $\{i,k,l,x\}$ résultant de l'optimisation étant incluses dans les données mises à jour.

15. La méthode selon la revendication 1, dans laquelle le critère de partage est un ratio de compteurs à partager entre les premier et deuxième lots ou un nombre maximal de compteurs dans le deuxième lot.

16. La méthode selon la revendication 1, dans laquelle les similarités calculées en (iii) sont classifiées et analysées par rapport à des conditions préétablies de détection de données aberrantes indicatives de non-conformité électriques potentielles.

17. La méthode selon l'une des revendications précédentes, comportant, pour évaluer une résistance de raccordement d'un compteur à un transformateur de distribution auquel d'autres compteurs sont raccordés, les étapes de:

obtenir des enregistrements de tensions et de consommations de chaque compteur raccordé au transformateur de distribution; et
évaluer la résistance de raccordement $R_i$ du compteur par un rapport de sommes de dérivées discrètes selon l'équation suivante:

$$R_i = -\frac{\sum\limits_{n=2}^{N}\left(\partial v_{i,n} - \partial v_{k,n}\right)\cdot\partial c_{i,n}}{\sum\limits_{n=2}^{N}\left(\partial c_{i,n}\right)^2}$$

où $i$ représente un indice du compteur parmi tous les compteurs, $n$ représente un intervalle temporel parmi une durée couvrant $N$ enregistrements de tensions $v$ et de consommations $c$ du compteur $i$, $k$ représentant un indice du transformateur de distribution parmi d'autres transformateurs de distribution, la tension $v_{k,n}$ étant une tension moyenne évaluée avec les enregistrements de tensions de tous les compteurs pour l'intervalle $n$.

18. Un système informatique de correction automatique d'une topologie d'un réseau de distribution électrique (300) définie par des attributions respectives de compteurs à des transformateurs, le système informatique comprenant au moins un dispositif de stockage d'une base de données topologiques (301) représentant la topologie du réseau de distribution électrique, au moins un dispositif de stockage d'enregistrements de tensions mesurées par les compteurs, et une unité de traitement (302) ayant une interface (305) pour communiquer avec les dispositifs de stockage, au moins un processeur (303) et une mémoire (304) stockant des instructions exécutables par le processeur, et configurant l'unité de traitement pour effectuer les étapes de:

(i) pour chaque transformateur de la topologie, partager les compteurs attribués au transformateur en des premier et deuxième lots selon un critère de partage et un degré de similarité des enregistrements de tensions mesurées par les compteurs par rapport à une tension moyenne évaluée avec les enregistrements de tensions mesurées par les compteurs attribués au transformateur de manière que le premier lot comprenne les compteurs dont le degré de similarité est plus élevé que les compteurs du deuxième lot; et **caractérisée en ce que**:

(ii) initialement pour chaque transformateur de la topologie puis subséquemment pour chaque transformateur dont l'attribution de compteurs a changé, calculer une tension moyenne corrigée avec les enregistrements de tensions mesurées par les compteurs uniquement dans le premier lot du transformateur;
(iii) calculer une similarité des enregistrements de tensions mesurées des compteurs dans les deuxièmes lots des transformateurs avec les tensions moyennes corrigées des transformateurs calculées en (ii);
(iv) pour chaque transformateur de la topologie, déterminer quels sont, dans le deuxième lot, les compteurs attribuables à un autre transformateur selon les similarités calculées en (iii);
(v) réattribuer au moins un des compteurs déterminés en (iv) et mettre à jour la base de données topologiques suivant une nouvelle attribution de l'au moins un des compteurs; et
(vi) tant qu'un compteur a été réattribué en (v), répéter les étapes (ii) à (v),

la topologie étant corrigée lorsqu'il ne reste plus de compteurs attribuables à d'autres transformateurs dans les deuxièmes lots.

**Patentansprüche**

1. Verfahren per automatischem Informatik-Korrektursystem einer Topologie eines elektrischen Verteilungsnetzes, die durch jeweilige Zuweisungen von Zählern zu Transformatoren definiert wird, wobei das Verfahren die Schritte umfasst:

(i) für jeden Transformator der Topologie Teilen (105) der dem Transformator zugewiesenen Zähler in erste und zweite Lose gemäß einem Kriterium zum Teilen und einem Ähnlichkeitsgrad (104) der Spannungsaufzeichnungen, die von den Zählern in Bezug auf eine durchschnittliche Spannung gemessen werden, die mit den Spannungsaufzeichnungen bemessen wird, die von den dem Transformator zugewiesenen Spannungen gemessen werden, derart, dass das erste Los die Zähler umfasst, deren Ähnlichkeitsgrad höher ist als die Zähler des zweiten Loses; und **dadurch gekennzeichnet, dass**:

(ii) zu Beginn für jeden Transformator der Topologie, dann anschließend für jeden Transformator, dessen Zuweisung von Zählern sich geändert hat, Berechnen (106) einer durchschnittlichen korrigierten Spannung mit den von den Zählern gemessenen Spannungsaufzeichnungen ausschließlich in dem ersten Los des Transformators;

(iii) Berechnen (107) einer Ähnlichkeit der gemessenen Spannungsaufzeichnungen der Zähler in den zweiten Losen der Transformatoren mit den der in (ii) berechneten korrigierten durchschnittlichen Spannungen Transformatoren;

(iv) für jeden Transformator der Topologie Bestimmen (108), welches in dem zweiten Los die Zähler sind, die gemäß den in (iii) berechneten Ähnlichkeiten einem anderen Transformator zuzuweisen sind;

(v) Neuzuweisen (113) wenigstens eines der in (iv) bestimmten Zähler; und

(vi) sofern ein Computer in (v) neu zugewiesen wurde, Wiederholen der Schritte (ii) bis (v), wobei die Topologie korrigiert wird, wenn keine Zähler mehr verbleiben, die anderen Transformatoren in den zwei Losen zugewiesen werden können.

2. Verfahren nach Anspruch 1, umfassend darüber hinaus den Schritt zwischen den Schritten (iv) und (v) zum Bevorzugen wenigstens eines Zählers, der gemäß einer absteigenden Reihenfolge der in (iii) berechneten Ähnlichkeiten neu zuzuordnen ist.

3. Verfahren nach Anspruch 1, bei dem die in (iii) berechnete Ähnlichkeit bestimmt wird in Abhängigkeit:

einer multidimensionalen Analyse der gemessenen Spannungsaufzeichnungen, wobei die Ähnlichkeit gemäß den Entfernungen zwischen den zeitlichen Serienspannungen der Aufzeichnungen in Bezug auf die durchschnittlichen Spannungen der Transformatoren quantifiziert werden, die in einem multidimensionalen Raum dargestellt werden;

einer Korrelationsanalyse zwischen den zeitlichen Serien der Aufzeichnungen;

oder von Ergebnissen einer Funktion, die die Ergebnisse der multidimensionalen Analysen und der Korrelation kombiniert.

4. Verfahren nach Anspruch 3, bei dem die in (iii) berechnete Ähnlichkeit darüber hinaus in Abhängigkeit von einem Beitrag von zeitlichen Serien der von den Zählern gemessenen Verbrauchsaufzeichnungen bestimmt wird.

5. Verfahren nach Anspruch 3, bei dem eine Vermittlung der Spannungsaufzeichnungen zwischen der multidimensionalen Analyse und der Korrelationsanalyse in Abhängigkeit von Verbrauchsniveaus durchgeführt wird, die ausgehend von entsprechenden zeitlichen Serien von Verbrauchsaufzeichnungen bestimmt werden, die von den Zählern gemessen werden.

6. Verfahren nach Anspruch 3, bei dem die die Ergebnisse kombinierende Funktion eine Hochrechnung einer Entfernung zu einer Korrelation gemäß der Gleichung umfasst:

$$\gamma_{a,b}^{d} = 1 - \frac{d_{a,b}^{2}}{2 \cdot \|\mathbf{V}_a\| \cdot \|\mathbf{V}_b\|}$$

wobei $V_a$ und $V_b$ Vektoren sind, die Serien von Spannungsaufzeichnungen entsprechen, die von einem Validierungszähler in dem multidimensionalen Raum gemessen werden, $d_{a,b}$ eine Entfernung zwischen den Enden der Vektoren in dem multidimensionalen Raum ist und $\|...\|$ ein Regeloperator ist.

7. Verfahren nach Anspruch 3, bei dem die in (iii) berechnete Ähnlichkeit für einen Zähler in der Validierung darüber hinaus umfasst:

eine Schätzung eines Anschlusswiderstandes des Zählers in der Validierung ausgehend von den Spannungsaufzeichnungen, die vom Zähler in der Validierung gemessen werden, eine durchschnittliche bemessene Spannung mit den Spannungsaufzeichnungen aller dem Transformator zugeordneten Zähler, die von der Ähnlichkeitsberechnung betroffen sind, und Größen, die eine Last am Zähler in der Validierung gemäß den Verbrauchsaufzeichnungen darstellen, die vom Zähler in der Validierung gemessen werden; und

eine Korrektur der Spannung, die vom Zähler in der Validierung in Abhängigkeit von dem geschätzten Anschlusswiderstand gemessen wird und den Verbrauchsaufzeichnungen, die vom Zähler in der Validierung gemessen werden.

8. Verfahren nach Anspruch 7, bei dem der Anschlusswiderstand des Zählers in der Validierung in Abhängigkeit von Amplitudenvariationen zwischen den Aufzeichnungen bemessen wird.

9. Verfahren nach Anspruch 7, bei dem ein elektrischer potenzieller Konformitätsmangel erkannt wird, je nachdem, ob der Anschlusswiderstand des Zählers in der Validierung einen Wert außerhalb einer vordefinierten gültigen Spanne aufweist.

10. Verfahren nach Anspruch 1, umfassend darüber hinaus vor dem Schritt (i) den Schritt des Auswählens der Datensegmente, die Zeitspannen der Aufzeichnungen definieren, in denen die Berechnungen in den Schritten (i) bis (iii) angewendet werden.

11. Verfahren nach Anspruch 10, umfassend darüber hinaus den Validierungsschritt der Daten in den Segmenten beim Erkennen von Störungen und Anomalien bei den Daten und beim Ablehnen der entsprechenden zeitlichen Aufzeichnungen.

12. Verfahren nach Anspruch 1, umfassend darüber hinaus die Schritte:

Kommunizieren mit einer topologischen Datenbank eines elektrischen Netzes zum Erhalten von Daten, die die Topologie des elektrischen Verteilungsnetzes anzeigen und zum Aktualisieren der Daten in Abhängigkeit von Neuzuweisungen der Zähler in (v); und
Kommunizieren mit einer Datenbank, die Messungen speichert, die von den Zählern geliefert werden, um die von den Zählern gemessenen Spannungsaufzeichnungen zu erhalten.

13. Verfahren nach Anspruch 12, bei dem die aktualisierten Daten eine Historie der Neuzuweisungen der Zähler zu den Transformatoren derart umfassen, dass eine Entwicklung der Topologie verfolgt wird und dass eine Konfiguration der Topologie zu einem bestimmten Zeitpunkt bestimmbar wird.

14. Verfahren nach Anspruch 12, bei dem die in (iii) berechnete Ähnlichkeit darüber hinaus umfasst:

ein Erkennen einer Neuzuweisung eines Indexzählers $i$ eines Transformators $k$ zu einem Transformator $l$; und
eine Optimierung einer zeitlichen Lokalisierung der Neuzuweisung durch Berechnen einer Ähnlichkeit für unterschiedliche zeitliche Positionen x der Neuzuweisung vor und nach der Neuzuweisung des Zählers, wie z. B.

$$S_{i,k,l,x} = S^g_{i,\left(k_{n<x}, l_{n>x}\right)}$$

wobei x eine positive ganze Zahl ist, wie z. B. $x \, \varepsilon \, \{0, 1, 2, 3 \, ..., N\}$, die eine Berechnungsspanne für den zeitlichen Index n bestimmt, wobei die Position, die die größte Ähnlichkeit ergibt, festgehalten wird, wobei die Informationen $\{i, k, l, x\}$, die aus der Optimierung resultieren, in den aktualisierten Daten eingeschlossen sind.

15. Verfahren nach Anspruch 1, bei dem das Kriterium zum Teilen ein Verhältnis von zwischen dem ersten und zweiten Los zu teilenden Zählern oder eine maximale Anzahl von Zählern in dem zweiten Los ist.

16. Verfahren nach Anspruch 1, bei dem die in (iii) berechneten Ähnlichkeiten in Bezug auf vorab festgelegte Bedingungen zur Erkennung von abweichenden Daten berechnet werden, die potenzielle elektrische Konformitätsmängel anzeigen.

17. Verfahren nach einem der voranstehenden Ansprüche, umfassend zum Bemessen eines Anschlusswiderstandes eines Zählers an einen Verteilungstransformator, an den andere Zähler angeschlossen werden, die Schritte:

Erhalten der Spannungs- und Verbrauchsaufzeichnungen jedes an den Verteilungstransformator angeschlossenen Zählers; und
Beurteilen des Anschlusswiderstandes $R_i$ des Zählers durch ein Verhältnis von Summen diskreter Ableitungen gemäß der folgenden Gleichung:

$$R_i = -\frac{\sum_{n=2}^{N}\left(\partial v_{i,n} - \partial v_{k,n}\right)\cdot\partial c_{i,n}}{\sum_{n=2}^{N}\left(\partial c_{i,n}\right)^2}$$

wobei $i$ einen Index des Zählers aus allen Zählern darstellt, $n$ ein zeitliches Intervall aus einer Dauer darstellt, die $N$ Spannungsaufzeichnungen v und Verbrauchsaufzeichnungen c des Zählers $i$ darstellt, wobei $k$ einen Index des Verteilungstransformators aus anderen Verteilungstransformatoren darstellt, wobei die Spannung $v_{k,n}$ eine bemessene durchschnittliche Spannung mit den Spannungsaufzeichnungen aller Zähler für das Intervall n ist.

18. Automatisches Korrektur-Informatiksystem einer Topologie eines elektrischen Verteilungsnetzes (300), die von jeweiligen Zuweisungen von Zählern zu Transformatoren definiert wird, wobei das Informatiksystem wenigstens eine Speichervorrichtung einer topologischen Datenbank (301), die die Topologie des elektrischen Verteilungsnetzes darstellt, wenigstens eine Speichervorrichtung von Spannungsaufzeichnungen, die von den Zählern gemessen werden, und eine Verarbeitungseinheit (302), die eine Schnittstelle (305) zum Kommunizieren mit den Speichervorrichtungen, wenigstens einen Prozessor (303) und einen Speicher (304), der die von dem Prozessor ausführbaren Anweisungen speichert, umfasst und eine Verarbeitungseinheit zum Durchführen der Schritte konfiguriert:

(i) für jeden Transformator der Topologie Teilen der Zähler, die dem Transformator in erste und zweite Lose gemäß einem Kriterium zum Teilen und einem Ähnlichkeitsgrad der von den Zählern gemessenen Spannungsaufzeichnungen in Bezug auf eine bemessene durchschnittliche Spannung mit den Spannungsaufzeichnungen, die von den Zählern gemessen werden, die dem Transformator zugeteilt werden, derart, dass das erste Los die Zähler umfasst, deren Ähnlichkeitsgrad höher ist als die Zähler des zweiten Loses, zugewiesen werden; und **dadurch gekennzeichnet, dass**:

( ii) zu Beginn für jeden Transformator der Topologie, dann anschließend für jeden Transformator, dessen Zuweisung von Zählern sich geändert hat, Berechnen einer durchschnittlichen korrigierten Spannung mit den von den Zählern gemessenen Spannungsaufzeichnungen ausschließlich in dem ersten Los des Transformators;

( iii) Berechnen einer Ähnlichkeit der gemessenen Spannungsaufzeichnungen der Zähler in den zweiten Losen der Transformatoren mit den in (ii) berechneten korrigierten durchschnittlichen Spannungen der Transformatoren;

( iv) für jeden Transformator der Topologie Bestimmen, welches in dem zweiten Los die Zähler sind, die gemäß den in (iii) berechneten Ähnlichkeiten einem anderen Transformator zuzuweisen sind;

( v) Neuzuweisen wenigstens eines der in (iv) bestimmten Zähler und Aktualisierung der topologischen Datenbank gemäß einer neuen Zuteilung des wenigstens einen der Zähler; und

( vi) sofern ein Computer in (v) neu zugewiesen wurde, Wiederholen der Schritte (ii) bis (v), wobei die Topologie korrigiert wird, wenn keine Zähler mehr verbleiben, die anderen Transformatoren in den zwei Losen zugewiesen werden können.

**Claims**

1. A computer implemented method for automatic correction of a topology of an electrical distribution network defined by respective allocations of meters to transformers, the method comprising the steps of:

(i) for each transformer of the topology, dividing up (105) the meters allocated to the transformer into first and second batches according to a dividing criteria and a degree of similarity (104) of the records of voltages measured by the meters with respect to an average voltage estimated with the records of voltages measured by the meters allocated to the transformer so that the first batch comprises the meters whose degree of similarity is higher than the meters of the second batch; and **characterized in that**:

(ii) initially for each transformer of the topology then subsequently for each transformer whose allocation of meters has changed, calculating (106) a corrected average voltage with the records of voltages measured by the meters only in the first batch of the transformer;

(iii) calculating (107) a similarity of the records of voltages measured by the meters in the second batches of the transformers with the corrected average voltages of the transformers calculated in (ii);

(iv) for each transformer of the topology, determining (108) which are, in the second batch, the meters attributable to another transformer according to the similarities calculated in (iii);

(v) reallocating (113) at least one of the meters determined in (iv); and

(vi) as long as a meter has been reallocated in (v), repeating steps (ii) to (v),

the topology being corrected when there remain no more meters attributable to other transformers in the second batches.

2. The method according to claim 1, further comprising the step, between steps (iv) and (v), of prioritizing at least one meter to be reallocated according to a decreasing order of the similarities calculated in (iii).

3. The method according to claim 1, wherein the similarity calculated in (iii) is determined as a function of:

a multidimensional analysis of the records of voltages measured, the similarity being quantified according to distances between voltages of time-series of the records with respect to the average voltages of the transformers represented in a multidimensional space;

a correlation analysis between the time-series of the records;

or results of a function combining results of the multidimensional and correlation analyses.

4. The method according to claim 3, wherein the similarity calculated in (iii) is further determined as a function of a contribution of time-series of records of consumptions measured by the meters.

5. The method according to claim 3, wherein a switching of the records of voltages between the multidimensional analysis and the correlation analysis is carried out as a function of consumption levels determined from corresponding time-series of records of consumptions measured by the meters.

6. The method according to claim 3, wherein the function combining the results comprises a remapping of a distance towards a correlation according to the equation:

$$\gamma_{a,b}^{d} \equiv 1 - \frac{d_{a,b}^{2}}{2 \cdot \|\mathbf{V}_{a}\| \cdot \|\mathbf{V}_{b}\|}$$

where $V_a$ and $V_b$ are vectors corresponding to series of records of voltages measured by a meter under validation in the multidimensional space, $d_{a,b}$ is a distance between ends of the vectors in the multidimensional space, and $\|...\|$ is a norm operator.

7. The method according to claim 3, wherein the similarity calculated in (iii) for a meter under validation further comprises:

an estimation of a connection resistance of the meter under validation from the records of voltages measured by the meter under validation, an average voltage estimated with the records of voltages of all the meters connected to the transformer targeted by the calculation of similarity, and values representative of a load at the meter under validation according to records of consumptions measured by the meter under validation; and

a correction of the voltage measured by the meter under validation as a function of the connection resistance estimated and the records of consumptions measured by the meter under validation.

8. The method according to claim 7, wherein the connection resistance of the meter under validation is estimated as a function of variations of amplitudes between the records.

9. The method according to claim 7, wherein a potential electrical non-compliance is detected when the connection resistance of the meter under validation has a value outside a predefined valid range.

10. The method according to claim 1, further comprising, before step (i), the step of selecting data segments defining time-stamped ranges of the records to which the calculations in steps (i) to (iii) are applied.

**11.** The method according to claim 10, further comprising the step of validating the data in the segments by detecting blackouts and anomalies in the data and by rejecting the corresponding time-stamped records.

**12.** The method according to claim 1, further comprising the steps of:

communicating with a topological database of an electrical network to obtain data indicative of the topology of the electrical distribution network and updating the data as a function of the reallocations of the meters in (v); and communicating with a database storing measurements provided by the meters to obtain the records of voltages measured by the meters.

**13.** The method according to claim 12, wherein the updated data comprise a history of the reallocations of the meters to the transformers in order to keep track of an evolution of the topology and that a configuration of the topology at a given time be determinable.

**14.** The method according to claim 12, wherein the similarity calculated in (iii) further comprises:

a detection of a reallocation of a meter of index $i$ of a transformer $k$ towards a transformer $l$; and an optimization of a time-stamped location of the reallocation by calculating a similarity for different time positions $x$ of reallocation before and after the reallocation of the meter such as

$$s_{i,k,l,x} = s^g_{i,\left(k_{n<x}, l_{n\geq x}\right)}$$

where $x$ is a positive integer such as $x \in \{0,1,2,3..., N\}$ determining a calculation range for the time index $n$, the position that gives the highest similarity being retained, the information $\{i,k,l,x\}$ resulting from the optimization being included in the updated data.

**15.** The method according to claim 1, wherein the dividing criteria is a ratio of meters to be distributed between the first and second batches or a maximum number of meters in the second batch.

**16.** The method according to claim 1, wherein the similarities calculated in (iii) are classified and analyzed with respect to preestablished conditions of detection of outliers indicative of potential electrical non-compliances.

**17.** The method according to one of the preceding claims, comprising, for estimating a connection resistance of a meter to a distribution transformer to which other meters are connected, the steps of:

obtaining records of voltages and of consumptions of each meter connected to the distribution transformer; and estimating the connection resistance $R_i$ of the meter by a ratio of sums of discrete derivatives according to the following equation:

$$R_i = -\frac{\sum_{n=2}^{N}\left(\partial v_{i,n} - \partial v_{k,n}\right) \cdot \partial c_{i,n}}{\sum_{n=2}^{N}\left(\partial c_{i,n}\right)^2}$$

where $i$ represents an index of the meter among all the meters, $n$ represents a time interval among a time length covering $N$ records of voltages $v$ and of consumptions $c$ of the meter $i$, $k$ representing an index of the distribution transformer among other distribution transformers, the voltage $v_{k,n}$ being an average voltage estimated with the records of voltages of all the meters for the time interval $n$.

**18.** A computer system for automatic correction of a topology of an electrical distribution network (300) defined by respective allocations of meters to transformers, the computer system comprising at least one storage device for a database of topological data (301) representing the topology of the electrical distribution network, at least one storage device for records of voltages measured by the meters, and a processing unit (302) having an interface (305) for communicating with the storage devices, at least one processor (303) and a memory (304) storing instructions executable by the processor and configuring the processing unit to perform the steps of:

(i) for each transformer of the topology, dividing up the meters allocated to the transformer into first and second batches according to a dividing criteria and a degree of similarity of the records of voltages measured by the meters with respect to an average voltage estimated with the records of voltages measured by the meters allocated to the transformer so that the first batch comprises the meters whose degree of similarity is higher than the meters of the second batch; and **characterized in that**:

(ii) initially for each transformer of the topology then subsequently for each transformer whose allocation of meters has changed, calculating a corrected average voltage with the records of voltages measured by the meters only in the first batch of the transformer;
(iii) calculating a similarity of the records of voltages measured by the meters in the second batches of the transformers with the corrected average voltages of the transformers calculated in (ii);
(iv) for each transformer of the topology, determining which are, in the second batch, the meters attributable to another transformer according to the similarities calculated in (iii);
(v) reallocating at least one of the meters determined in (iv) and updating the database of topological data following a new allocation of the at least one of the meters; and
(vi) as long as a meter has been reallocated in (v), repeating steps (ii) to (v),

the topology being corrected when there remain no more meters attributable to other transformers in the second batches.

FIG. 1

FIG. 2

FIG. 3

FIG. 4

Début

Selection des segments
temporels de données
— 101

Validation des segments
et génération des masques

102

103
Pour chaque transformateur

Calcul de similarité
— 104

Partage des compteurs entre
$I$ compteurs immuables
et $M$ compteurs mobiles
— 105

Calcul de la tension moyenne
à partir des compteurs immuables
— 106

Calcul des similarités des
compteurs mobiles de tous
les transformateurs avec
les tensions moyennes
— 107

108
Parmi tous les transformateurs
choisir lequel des compteurs
mobiles pourrait être attribué
à un autre transformateur.

Si le compteur peut être
déplacé alors corriger
la base de données

Liste des
non-conformités
électriques
— 117

Au moins un compteur est déplacé
— 113

Oui

Non

Terminé

FIG. 5

FIG. 6A

FIG. 6B

FIG. 7

108

Pour chaque transformateur

Choisir lequel des compteurs
mobiles pourrait être attribué
à un autre transformateur

110

Un compteur peut être déplacé

111

Oui          112

Correction de la
base de données

Non

Transformateur suivant

FIG. 8

**Histogramme consommation du compteur « $i$ »**

FIG. 9A

Compte

128 silencieux

124 bruyant

Valeur de $|c_i|$

**Histogramme consommation totale**

Compte

Réseau
silencieux
126

Réseau bruyant
130

FIG. 9B

Réseau silencieux

Somme des consommations

**Histogramme consommation relative**

Compte

142

140

FIG. 9C

$|c_i|$ / somme des consommations

FIG. 10

compteur $i$

transformateur $k$

transformateur $l$

200

Sélectionner au moins
un segment

Concaténer la sélection 201

Déterminer
- la plage de recherche
- le pas de recherche 202

Calcul de la position $x$
à tester 203

Calcul de la similarité
pour $\{i,k,l,x\}$ 204

205

Non —— Dernière position calculée

Oui

Extraire la position x
qui correspond au
maximum de similarité 206

Ranger la correction
dans la base de données 207

FIG. 11

FIG. 12

EP 3 391 507 B1

**EP 3 391 507 B1**

**RÉFÉRENCES CITÉES DANS LA DESCRIPTION**

**Documents brevets cités dans la description**

- US 20150241482 A, Sonderegger
- US 9285242 B, Arya
- US 9214836 B, Flammer, III
- US 20160131501 A, Steigler
- US 20140100821 A, Léonard